(19) Europäisches Patentamt / European Patent Office / Office européen des brevets

(11) **EP 4 682 885 A1**

(12) **EUROPEAN PATENT APPLICATION**

(43) Date of publication:
**21.01.2026 Bulletin 2026/04**

(21) Application number: **24189216.5**

(22) Date of filing: **17.07.2024**

(51) International Patent Classification (IPC):
*G11C 11/56* (2006.01)

(52) Cooperative Patent Classification (CPC):
G11C 11/5642

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Friedrich-Alexander-Universität Erlangen-Nürnberg 91058 Erlangen (DE)**

(72) Inventors:
• **PRABAHAR, John Reuben**
  **91054 Erlangen (DE)**
• **FEY, Dietmar**
  **91054 Erlangen (DE)**

(74) Representative: **König, Andreas Rudolf et al Schoppe, Zimmermann, Stöckeler Zinkler, Schenk & Partner mbB Patentanwälte Radlkoferstraße 2 81373 München (DE)**

(54) **COMPARATOR DEVICE AND METHOD FOR EVALUATING A MULTI-BIT MEMORY CELL**

(57) A comparator device for providing an evaluation result derived from comparing an input signal and a reference signal, comprises an interface for receiving the input signal, a reference voltage for providing the reference signal a first comparator circuit configured for a first comparison based on the input signal and the reference signal and to provide a first part of the evaluation result. A second comparator circuit is configured for a second comparison based on the input signal and the same reference signal and to provide a second part of the evaluation result. A current source circuitry is associated with the second comparator circuit and configured for, based on the first part of the evaluation result and for the second comparison, providing an electrical tuning current for scaling the input signal or for scaling the reference signal with the electrical tuning current.

Fig. 1

EP 4 682 885 A1

**Description**

The present invention relates to a comparator device for providing an evaluation result based on a comparison. The present invention further relates to a memory device having such a comparator device, e.g., used for evaluating multi-bit memory cells. The present invention further relates to a method for evaluating a multi-bit memory cell and, more particularly, to a method to read from multi-bit resistive random access memory using a single voltage reference.

In several technical fields, there is an aim to quantize signals into one of a member of predefined values. An example thereof is given in the field of quantizing of resistance values such as of multi-bit memory cells of a non-volatile memory, NVM. Such a memory can retain data without any source of electrical power.

Flash memory is a widely used NVM and has been the D-facto standard for large storage. However, flash memory is facing certain limitation like poor endurance ($10^3$ to $10^5$ erase cycles), modest retention (typically ten years on a new device), long erase time (in the range of ms) and high operating voltage (around 15 V). This has led to intense research efforts in the last decade to find alternatives to flash as the standard non-volatile memory.

Emerging the non-volatile memories like resistive random access memory, ReRAM, Phase-change memory, PCM, Spin-Transfer Torque magnetoresistive RAM, STT-MRAM, and Ferroelectric memories are possible candidates being explores in the last decade. Due to its advantages like scalability and small area occupied, ReRAM technology has reached sufficient maturity and is already manufactured in the industry.

In ReRAM, the data is stored as resistance. The ReRAM memory cell is a two terminal structure, top and bottom electrode with an oxide layer between them. The oxide is basically an insulator and does not conduct current under normal circumstances. This is the High Resistance State, HRS, of the device. However, when an appropriate voltage is applied, due to the chemical reactions (redox reaction or electrochemical metallization), a conductive filament is formed in the oxide insulator which conducts current and in this manner, the memory cell is switched to a Low Resistance State. When a voltage of opposite polarity is applied across the device, the conductive filament is ruptured and the memory device is switched back to HRS. One of the important focus of research in these emerging NVMs is multi-bit storage. This is due to the increasing demand from consumers for more and more data storage capacity on their portable devices.

One of the common ways in which ReRAM cells are arranged in an array is the 1T-1R structure in which memory cell is fabricated with a transistor to enable access to the memory device, i.e., one transistor and one ReRAM device form a memory cell. The transistor in one 1T-1R structure plays a dual role. In addition to functioning as an access device to select a particular cell, it also limits the maximum current that can flow through the memory cell, avoiding over-programming of the memory cells. Multi-bit storage 1T-1R ReRAM array is accomplished by varying the gate voltage of the access transistor during programming. For device transitions from HRS to LRS, the gate voltage of the transistor can be varied to program the ReRAM cell to different Low Resistance States. The physical process behind this phenomenon is that increased gate voltage results in increased drain-to-source current and consequently in a thicker filament. ReRAMs have been successfully programmed to multiple states (single HRS and different LRS) by aforementioned gate voltage modulation [1, 2]. Other than this gate voltage modulation, there are also other ways to program ReRAM cell to multiple states. For such ReRAMs which can be programmed to more than two states, READ (sensing) circuit need to be developed to convert the states of the NVM cell into a digital data, so that they can be processed further.

Conventionally, there were two methodologies pursued to sense multi-bit memories/sequential and parallel. Both were developed to sense multi-bit flash memories. In a sequential approach to multi-bit sensing, a single comparator is used and numerous comparisons are made by varying the reference quantity (voltage or current) sequentially, resulting in the identification of the cell resistance [3]. The parallel approach uses numerous comparators and compares the read quantity with the reference quantity simultaneously, similar to a flash ADC [4]. The former approach has less hardware complexity but incurs latency, while the latter achieves high speed sensing at the cost of hardware.

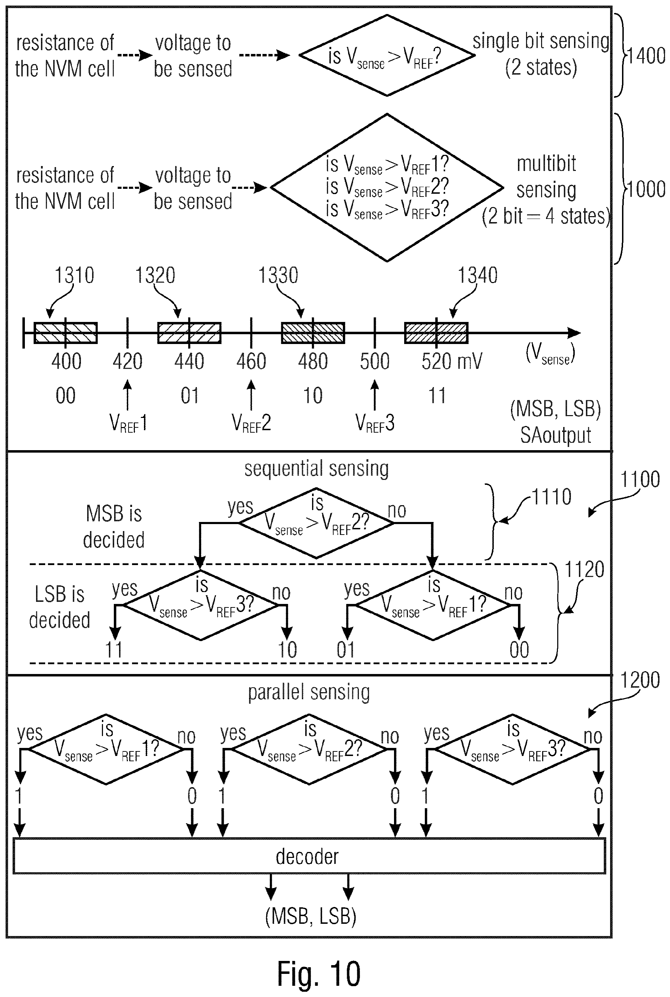

Fig. 10 illustrates both the conventional types. The sequential sensing 1100 illustrated in Fig. 10 is also called dichotomic (binary search) approach and in this methodology, the Most Significant Bit (MSB) is first decided by comparing $V_{sense}$ with the center $V_{REF}$ and based on the MSB, one of the other $V_{REF}$s is used to decide the Least Significant Bit (LSB) [3, 5]. Although only two $V_{REF}$s are used for sensing a particular state, sequential sensing nevertheless requires three $V_{REF}$s to be generated on-chip. In fact, both sequential sensing 1100 and parallel sensing 1200 require three $V_{REF}$s to be generated on-chip to sense four states 1310, 1320, 1330 and 1340. However, when compared to a single-bit sensing 1400, a multi-bit sensing 1100 allows to increase the amount of information to be obtained. In addition to the use of three $V_{REF}$s, sequential sensing requires a control circuitry to choose the second $V_{REF}$ (and connect it to the comparator) based on the first $V_{REF}$ and sensing is performed in two stages 1110 and 1120.

In other words, in multi-bit sensing, resistance of the NVM cell is converted to a voltage and compared with a reference voltage. Conventionally, two popular methods were used. Assuming the voltage to be sensed varies from 400 mV to 520 mV, in sequential sensing, a center $V_{REF}$ of 460 mV is compared with $V_{sense}$ (voltage

to be sensed) to decide the MSB. If MSB is 1, a higher $V_{REF}$ of 500 mV is used to decide the LSB. On the contrary, if MSB is 0, a lower $V_{REF}$ of 420 mV is used to decide the LSB. In parallel sensing, $V_{sense}$ is compared with three $V_{REF}$s simultaneously and their outputs are decoded to two bits.

In the art, there are known such read-out circuits (called comparators or Sense Amplifiers) for multi-bit NVM. US 6,747,892 B2 discloses a sense amplifier to quickly read from multi-bit flash memory with high accuracy. It requires multiple control gate voltages which needs to be applied sequentially for sensing multi-bit data. US 6,069,821 also discloses a Sense Amplifier to reliably read from multi-bit flash memory. To distinguish between four states, there are used four $V_{REF}$s and $I_{REF}$.

US 7,352,618 B2 follows the dichotomic approach by sensing the MSB first followed by the LSB for NOR flash memory. The SA uses a reference voltage generator to generate three different voltages which are converted to three different $I_{REF}$s and fed to the SA for sensing.

US 2011/0149660 A1 uses a ramp voltage (linearly increasing voltage) at the gate of the flash memory cell, so that the pre-charged Bit Line discharges to different voltages according to the multi-level cell, MLC, state of the memory cell. Yet again, the discharged Bit Line, BL, voltage is compared with different $V_{REF}$s to ascertain the state. On-chip voltage (current) reference generators require more area since they have to be designed to be insensitive to variations in process, voltage, temperature, PVT. Usually, a voltage reference circuit outputs a single precise voltage [6]. Generating multiple $V_{REF}$s consumes more circuitry (area) and power on silicon. For sensing two-bit data, three $V_{REF}$s are needed.

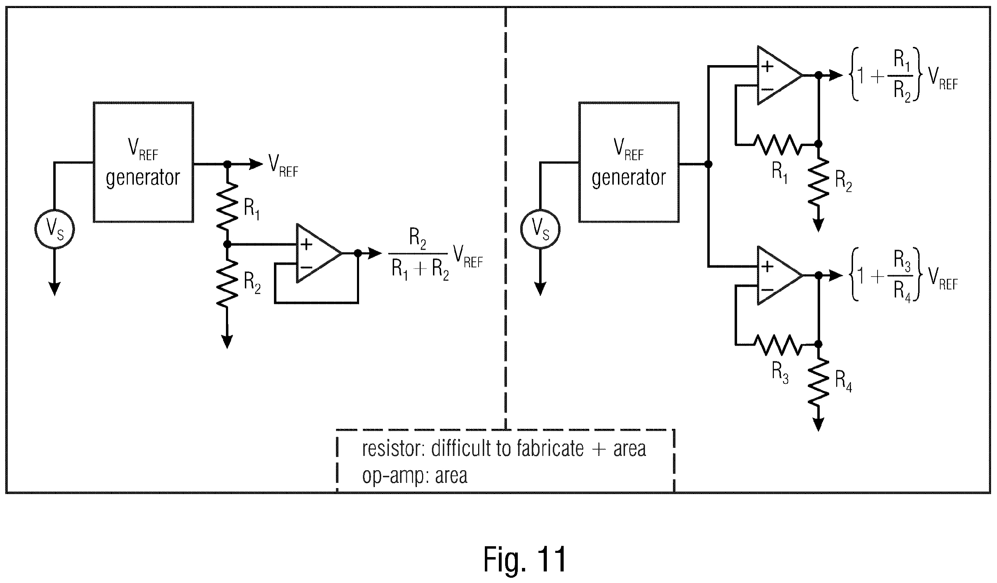

These $V_{REF}$s need to be generated on-chip which will be area and power consuming even if one $V_{REF}$ is generated and the remaining two $V_{REF}$s are derived from the first $V_{REF}$. Although multiple $V_{REF}$s can be generated from a single $V_{REF}$ using resistors and op-amps as shown in Fig. 11, it will be inefficient due to the area required to fabricate an on-chip resistor and the non-idealities involved in fabricating an accurate resistor [7, 8].

Whilst on the left hand side of Fig. 11 there is shown a concept to derive $V_{REF}$ and $(R_2/(R_1+R_2))\, V_{REF}$ based on a single op-amp and a voltage divider, the right hand side shows a different concept using a second op-amp and an increased number of resistors. In Fig. 11, there are shown common ways to generate multiple $V_{REF}$s from a single $V_{REF}$ including voltage divider networks or using two op-amps as non-inverting amplifiers. Both require resistors which are difficult to fabricate and occupy area in addition to requiring op-amps [11].

Multiple $V_{REF}$ generation circuits might be needed to generate multiple $V_{REF}$s since deriving a $V_{REF}$ from another $V_{REF}$ is not straight forward. Indeed, this problem is severe and there are dedicated works which try to generate the multiple distinct $V_{REF}$s without using resistors. For example, two $V_{REF}$s are generated in a single circuit and such a circuit occupied more area compared to a circuit which generates a single $V_{REF}$ [9]. Body biasing technique is used to generate multiple $V_{REF}$s in [10]. All this proves that multiple $V_{REF}$ generation on-chip is difficult and power consuming.

It is, thus, an aim to provide for multi-bit sensing of an input signal that requires a low chip area and a low amount of power.

An object of the present invention is, thus, to provide for a precise evaluation of an input signal with a single reference voltage to derive at least two parts of an evaluation result.

This object is achieved by the subject-matter as defined in the independent claims.

A recognition of the underlying invention is that instead of generating additional $V_{REF}$s for deciding about lower significant bits such as the LSB, it is possible to adjust the signals to be compared in a comparator. Thereby, a similar effect than adapting the reference voltage may be obtained without requiring a voltage providing circuitry.

According to an embodiment, a comparator device is configured for providing an evaluation result derived from comparing an input signal and a reference signal, the comparator device comprising an interface for receiving the input signal, a reference voltage source for providing the reference signal and a first and a second comparator circuit. The first comparator circuit is configured for a first comparison based on the input signal and the reference signal and to provide a first part of the evaluation result. The second comparator circuit is configured for a second comparison based on the input signal and the same reference signal and to provide a second part of the evaluation result. The comparator device comprises a current source circuitry being associated with the second comparator circuit and configured for, based on the first part of the evaluation result and for the second comparison, providing an electrical tuning current for scaling the input signal or for scaling the reference signal with the electrical tuning current. This allows to avoid further reference voltage sources.

According to an embodiment, the comparator device is configured to evaluate an electrical resistance value providing the input signal. This allows a beneficial implementation of read-out circuits for resistive memory devices. According to an embodiment, the comparator circuit is a read-out circuit for a non-volatile memory device which allows to have read-out circuits consuming a low amount of power which is of advantage especially for mobile devices.

According to an embodiment, the evaluation result comprises at least two bit of information derived from the input signal, wherein the first comparison is related to determining a first bit of the at least two bits and the second comparison is related to determining a second bit of the at least two bits. Such a comparator device may be used to sense multi-bit memory cells whilst requiring a low amount of chip area and electrical power.

According to an embodiment, the comparator device is configured for scaling the input signal or a reference signal of the second comparator circuit based on the first part of the evaluation result, wherein the current source circuitry comprises a MOSFET element as a voltage controlled current source configured for providing the tuning current with a current amplitude that corresponds to a difference of threshold values of the evaluation result. This allows to advantageously use the MOSFET as a current source as they are precisely scalable and adjustable to deliver a certain amount of current when being fed with a specific voltage such as the reference voltage or the sense voltage.

According to an embodiment, the comparator device is adapted such that the current source circuitry is configured for scaling the input signal or the reference signal for the second comparator circuit based on the first part of the evaluation result, wherein the input signal and the reference signal are provided as current signals equivalent to voltage signals thereof, wherein scaling the current signals with the tuning current causes a scaling of the equivalent voltage signals. This allows to precisely modify the signals to be compared in the second comparator circuit.

According to an embodiment, the first part of the evaluation result and the second part of the evaluation result are parts of a multi-bit decision of the input signal, wherein the input signal is decided to be one of a multitude of predefined discrete states of a voltage of the input signal, each predefined discrete state being associated with a voltage range of the input signal. Between two adjacent voltage ranges, one of a plurality of threshold voltages is arranged. The current source circuitry is configured for providing the electrical tuning current that is associated with a voltage difference between two adjacent threshold voltages. This allows to offset the second decision/comparison by a predefined value which is of increased advantage especially for multi-bit memory cells but not limited thereto.

According to an embodiment, the first comparator circuit is configured for providing the first part of the evaluation result as a first output signal. The current source circuitry is configured for receiving the first output signal and comprises a transistor arrangement having a voltage/current characteristic that provides the electrical tuning current with an equivalent to the voltage difference based on the first output signal. For example, the first part of the evaluation result indicating a first value of a bit, e.g. 0 or 1 may cause the current source circuitry to provide the electrical tuning current to either the reference signal or the input signal.

According to an embodiment, the comparator device comprises a delay element coupled with the second comparator circuit, wherein the second comparator circuit is adapted to start the second comparison after the first comparator circuit has finished the first comparison based on the delay element. Use of a delay element allows to precisely cause the second comparator circuit to start the comparison after the first comparator circuit that provides for an influence of the second comparison to securely deliver its result.

According to an embodiment, the first comparator circuit is adapted to indicate a most significant bit of a quantized value of the input signal, wherein the second comparator circuit is adapted to indicate a less significant bit of a quantized value of the input signal. This allows to obtain a multi-bit evaluation of the input signal.

According to an embodiment, the current source circuitry is a first current source circuitry for providing the electrical tuning current as a first electrical tuning current. The comparator device comprises at least a third comparator circuit and at least a further, second current source circuitry associated with the third comparator circuit. This second current source circuitry may be adapted for providing a second electrical tuning current, wherein a comparison provided by the third comparator circuit is based on a scaling of one of the reference signal and the input signal to provide the third comparison as an equivalent to a decision about the input signal with regard to a decision threshold being different from the first comparison and from the second comparison. The scaling of the third comparator circuit is based on the first part of the evaluation result and the second part of the evaluation result. This allows to obtain even more bits of information using the same reference voltage.

According to an embodiment, the comparator device is at least a part of an integrated circuit which allows for a small implementation of the device.

According to an embodiment, a memory device comprises a multitude of memory cells and a comparator device described herein, wherein the comparator device is configured for a readout of a memory cell for providing the evaluation result. This allows for small and energy-efficient memory devices.

According to an embodiment, a method for evaluating a multi-bit memory cell comprises obtaining an input signal from the memory cell and providing the input signal to a first comparator circuit and for comparing a voltage of the input signal with a reference voltage of a reference signal to determine a value of a first bit as a first part of an evaluation result. The method comprises providing the input signal to a second comparator circuit and either scaling the input signal to a tuned input signal or scaling the reference signal to a tuned reference signal based on the first part of the evaluation result. A second comparison of the second comparator circuit is based on the input signal, the reference signal and the scaling. For the second comparison thereby a different reference voltage is effective when compared to the first comparison.

Further embodiments of the present invention are subject of further dependent claims.

Preferred embodiments of the present invention are described herein after whilst making reference to the accompanying drawings. Therein:

Fig. 1     shows a schematic block diagram of a comparator device according to an embodiment;

Fig. 2     shows a known concept of a single-bit sensing using a comparator;

Fig. 3a     shows a schematic diagram of different voltage ranges between which a distinction is made by a conventional sequential sensing;

Fig. 3b     shows a schematic diagram representing an amendment of the concept of Fig. 3a according to an embodiment of the present invention;

Fig. 4a     shows a schematic block diagram of a further comparator device according to an embodiment and configured for sensing any electrical resistance;

Fig. 4b     shows a schematic block diagram of a comparator device according to an embodiment, configured to distinguish between four states of the input signal;

Fig. 4c     shows a schematic block diagram of a comparator device according to an embodiment and adapted to distinguish between three states of the input signal;

Fig. 4d     shows a schematic representation of a comparison logic for distinguishing between three states, according to an embodiment;

Fig. 5     shows a schematic diagram of signals that may be obtained with the comparator device of Fig. 4b;

Figs. 6a-f     show, with reference to Figs. 3a and 3b, one way to achieve accurate current scaling by adding a voltage controlled current source using a transistor according to an embodiment;

Fig. 7     shows a schematic representation of a comparison logic for distinguishing between eight states;

Fig. 8     shows a schematic block diagram of a comparator device according to an embodiment being able to distinguish between eight different states;

Fig. 9     shows a schematic flow chart of a method according to an embodiment;

Fig. 10     illustrates conventional types of resistance sensing; and

Fig. 11     shows common ways to generate multiple $V_{REF}$s from a single $V_{REF}$ including voltage divider networks or using two op-amps as non-inverting amplifiers.

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present invention. However, it will be apparent to those skilled in the art that embodiments of the present invention may be practiced without these specific details. In other instances, well known structures and devices are shown in block diagram form rather than in detail in order to avoid obscuring embodiments of the present invention. In addition, features of the different embodiments described hereinafter may be combined with each other, unless specifically noted otherwise.

Some of the embodiments described herein relate to a comparator device that is used to evaluate an input signal obtained from a memory cell. However, comparator circuits according to the present invention are not limited hereto but may allow to evaluate, e.g., quantize, input signals of different sources, possibly but not necessarily obtained from a resistor or electrical resistance value. Embodiments of the present invention relate to the concept of influencing a second comparison of a second comparative circuit with regard to a first comparator device by using the same signals used by the first comparator but to influence or tune either of the signals so that it is not necessary to use additional reference signals. This concept may be used not only for memory cells of a memory device but also for pressure sensors, temperature sensors, strain sensors and the like. Preferably but not necessarily such quantities are provided as a resistance by a transducer and then sensed in the electronic domain, i.e., a voltage. Embodiments may make use of a stable voltage so that it is preferred that both the reference voltage and the input signal are constant, at least for the time of comparison. It is preferred that the analog resistance is to be converted to an analog voltage and remains constant with respect to time during sensing. At the time of sensing, the voltage to be sensed may be applied, for example, to a gate terminal of a transistor and should therefore remain constant.

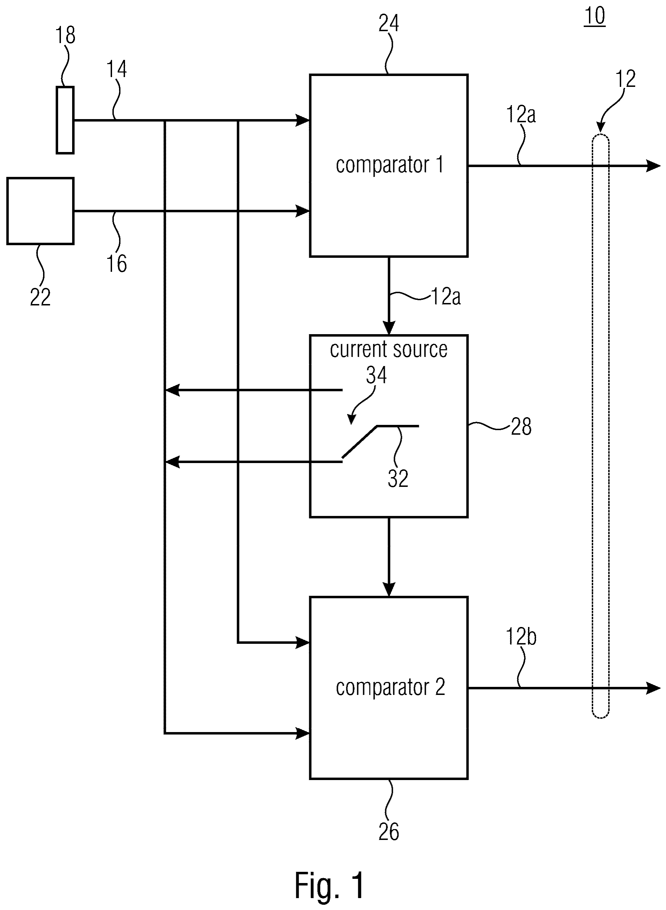

Fig. 1 shows a schematic block diagram of a comparator device 10 according to an embodiment. The comparator device 10 is configured for providing an evaluation result 12 derived from comparing an input signal 14 and a reference signal 16.

The comparator device 10 comprises an interface 18 configured for receiving the input signal 14. For example, the interface 18 may provide a physical connection to a physical quantity to be measured such as a resistance value or a resistor, e.g., as being part of a NVM.

The comparator device 10 further comprises a reference voltage source 22 configured for providing the reference signal 16.

A first comparator circuit 24 is configured for a comparison based on the input signal 14 and the reference signal 16 to provide a first part 12a of the evaluation result 12. For example, the comparator circuit 24 may compare voltages of the input signal 14 and the reference signal 16 and may provide the first part 12a as a signal having a high state or a low state dependent on a result of the comparison.

A second comparator circuit 24 is configured for a second comparison based on the input signal 14 and the same reference signal 16 and is configured to provide a second part 12b of the evaluation result.

The comparator device 10 comprises a current source circuitry 28 being associated with the second comparator circuit 26. The current source circuitry 28 is configured for providing an electrical tuning current 32 for scaling the input signal 14 or for scaling the reference signal 16 with the electrical tuning current 32. Tuning one of the input signal 14 and the reference signal 16 may be understood as providing additional current that adds up to the input signal 14, the reference signal 16, respectively. The current source circuitry 28 may be configured for applying the electrical tuning current 32 to only one of the input signal 14 and the reference signal 16 as indicated by an electrical switch 34.

Whether the current source circuitry tunes the input signal 14 or the reference signal 16 is based on the first part 12a of the evaluation result 12. As will be described later in more detail, instead of deciding about one of a plurality of additional $V_{REF}$s to be used for a further comparison, the current source circuitry may decide about the signal to be tuned to thereby offset the comparison which may result in a similar effect than using a different reference voltage. In other words, instead of selecting a higher or lower $V_{REF}$ based on the MSB as known in the art, the input signal or the reference signal may be tuned to obtain a similar effect.

Based on the electrical tuning current, the second comparator circuit 26 performs its comparison as comparing the tuned input signal with the reference signal or comparing the input signal with the tuned reference signal.

The current source circuitry 28 being associated with the second comparator circuit 26 may be understood as a current source circuitry that tunes the input signal 14 or the reference signal 16 for the comparison of the second comparator circuit 26 whilst not adapting the signals for the comparison performed in the first comparator circuit 24. The current source circuitry 28 may be a circuitry coupled to the comparator circuit 26 or may be a part thereof.

For describing the advantages of the present invention in a more illustrative manner, reference is made to known concepts.

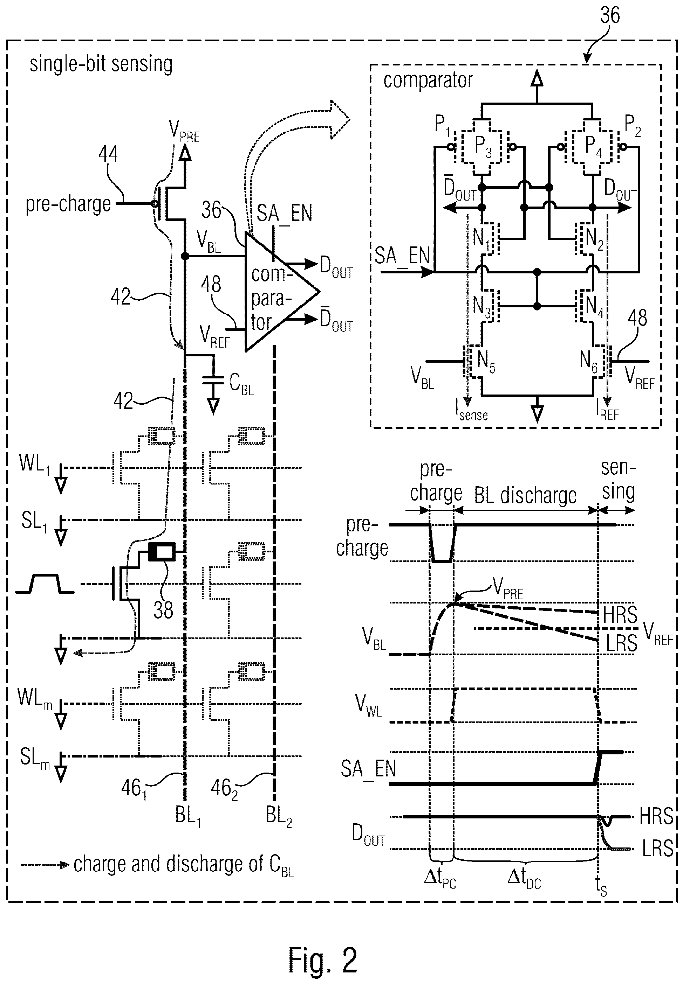

Fig. 2 shows a known concept of a single-bit sensing using a comparator 36 that may be implemented in accordance with the comparator 24 or 26. An electrical resistance element 38, e.g., a memory cell, may be used for a current flow 42 based on a signal 44 to precharge the bit line BL, e.g., bit line $46_1$. Other signals such as for the word line WL are known to the person skilled in the art. It is to be noted that a memory cell described herein is possibly but not necessarily a Resistive RAM cell but may also be a phase change memory, a magnetic memory based on spin or the like.

In the known evaluation or single-bit sensing, a time duration $\Delta t_{PC}$ is used to precharge the bit line, wherein thereafter a time interval $\Delta t_{DC}$ to discharge the bit line is used until a time ts where the sensing begins. Upon the discharge being different for the HRS and the LRS state, the voltage $V_{BL}$ on the bit line remaining at ts may be used to decide whether the state is high or low.

The comparator 36 is used for a comparison with a reference signal 48, i.e., $V_{REF}$, that may be similar to the reference signal 16. Based on the state of the cell being HRS or LRS the comparator circuit 36 outputs signals $D_{OUT}$ and $\overline{D}_{OUT}$, one being the inversion of the other.

In other words, in Fig. 2, the BL is first precharged to a specific voltage $V_{PRE}$. The precharged BL discharges according to the resistance of the memory cell during BL discharge phase $\Delta t_{DC}$. When SA_EN goes high, $\overline{D}_{OUT}$ discharges faster if $V_{BL}$ is greater than the $V_{REF}$. The faster discharge of the voltage at $\overline{D}_{OUT}$ is reinforced by the positive feedback formed by the cross-coupled inverters. Hence, $D_{OUT}$ remains high and $\overline{D}_{OUT}$ goes low for HRS sensing.

In Fig. 2, there is depicted the basic methodology to sense single-bit from a 1T-1R ReRAM array where the transistor functions as an access device and also limits the current through the cell while programming the memory cell. The sensing uses a voltage-mode sensing technique and the conceptual wave-forms are shown in Fig. 2. This voltage-mode sensing technique was originally presented in [12]. Embodiments may use a same or comparable technique with the comparator of [12] modified for current comparison, i.e., the voltages $V_{BL}$ and $V_{REF}$ are converted to equivalent currents $I_{sense}$ and $I_{REF}$ and then compared during sensing stage, see Fig. 2.

The PMOS transistor connected to the precharge signal 44 is used in Fig. 2 to pre-charge $BL_1$, bit line parasitic capacitance $C_{BL}$ respectively to a specific voltage $V_{PRE}$. When the word line, WL, of the cell which has to be sensed is activated, $C_{BL}$ which was precharged to $V_{PRE}$ starts to discharge in accordance with the resistance/state of the cell. If the cell is in HRS, the discharge rate is slow and $V_{BL} \approx V_{PRE}$. If the cell is in LRS, the rate of discharge is faster and $V_{BL}$ is much below $V_{PRE}$. At the end of BL discharge phase, the WL is deactivated and hence no more discharge is possible. The $V_{BL}$ is now stable and can be sensed by comparing it with the reference voltage $V_{REF}$.

A CMOS comparator 36 can be used to compare $V_{BL}$ and $V_{REF}$. The comparator depicted was proposed in [12] and can sense very minute difference in voltages very efficiently while consuming zero static power. However, embodiments may use such a comparator but are not limited hereto. Different configurations of comparators may be used.

The sensing of Fig. 2 starts when SA_EN goes high. Before SA_EN goes high, nodes $D_{OUT}$ and $\overline{D}_{OUT}$ are pre-charged to $V_{DD}$, i.e., the operational voltage, through $P_1$ and $P_2$. Also, $V_{BL}$ and $V_{REF}$ are connected to two NMOS transistors $N_5$ and $N_6$, whose source terminals are connected together and grounded. Therefore, the currents through $N_5$ and $N_6$ will be solely a function of their gate voltages. When SA_EN goes high, transistors $N_3$ and $N_4$ are ON and start to conduct current. If $V_{BL} > V_{REF}$, $N_5$ conducts more current than $N_6$, i.e., $I_{sense} > I_{REF}$. Therefore, $\overline{D}_{OUT}$ begins to discharge faster than $D_{OUT}$. However, $\overline{D}_{OUT}$ is the input for the inverter formed by $P_4$ - $N_2$. Hence, the drop in voltage at $\overline{D}_{OUT}$ leads to an increase in voltage at node $D_{OUT}$. This, in turn, reinforces the low at $\overline{D}_{OUT}$ because $D_{OUT}$ is the input to the inverter formed by the $P_3$ - $N_1$. In this manner, for HRS, $V_{BL}$ being greater than $V_{REF}$ is sensed as a logic HIGH at the $D_{OUT}$. Following a similar analysis, LRS which results in $V_{REF}$ being greater than $V_{BL}$ will be sensed as a logic LOW at $D_{OUT}$. Suppose HRS is 600 k$\Omega$ and LRS is 10 k$\Omega$ for a particular ReRAM technology. If the node is pre-charged to 300 mV, depending on the $C_{BL}$, the $V_{BL}$ gets discharged to 280 mV and 200 mV for HRS and LRS, respectively. Then, a $V_{REF}$ of 250 mV or the like can be used to sense HRS as logic HIGH and LRS as logic LOW.

Present embodiments propose to sense multi-bit values such as of an NVM using a single $V_{REF}$. According to some embodiments, when compared to known approaches, there is used only the center $V_{REF}$, i.e., a reference voltage being an average or median of the required ones therefore allowing to tune the comparison to lower thresholds and to higher thresholds to decide the MSB and based on the MSB bit, the crucial currents which determine the LSB are manipulated to differentiate four states without using any additional reference. For example, when implementing three thresholds or decisions, $V_{REF2}$ shown in Fig. 10 may be used. Since sensing according to embodiments is accomplished by current manipulation, it is preferable to use a sense amplifier that is amenable to current manipulation. Therefore, embodiments provide a sensing technique which differentiates between NVM states by current comparison.

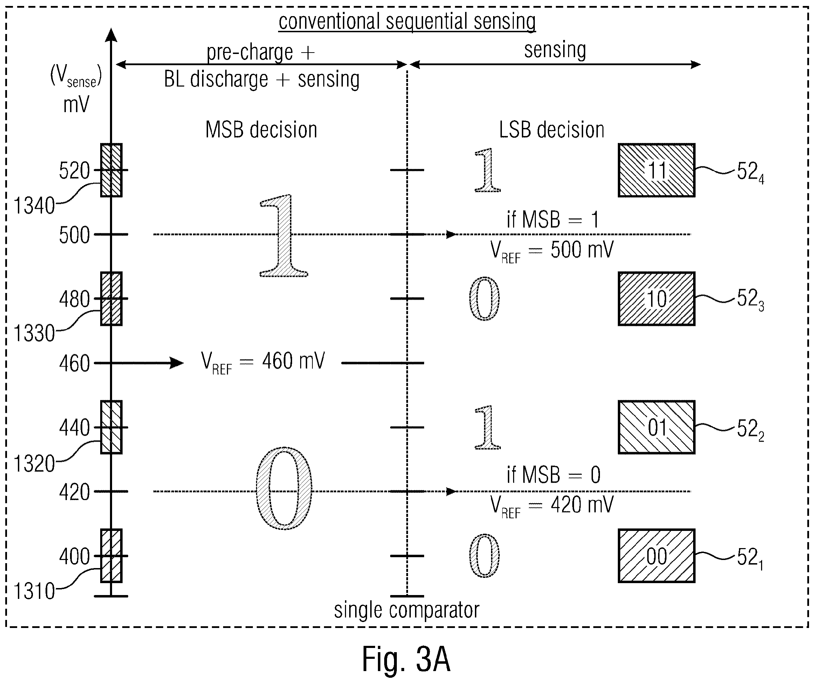

Fig. 3a shows a schematic diagram of different voltage ranges 1310, 1320, 1330 and 1340 between which a distinction is made by a conventional sequential sensing. First, a center $V_{REF}$ of 460 mV is used, wherein the voltages are given for explanatory reasons only. The center $V_{REF}$ of 460 mV separates two pairs of adjacent states 1310 and 1320 on the one hand and 1330 and 1340 on the other hand. Based on the result of the first level decision, the MSB, a different $V_{REF}$ of 420 mV, i.e., -40 mV or of 500 mV, i.e., +40 mV is used to distinguish between the two entities of the pairs of the first level to arrive at combinations $52_1$, $52_2$, $52_3$ or $52_4$ of bits.

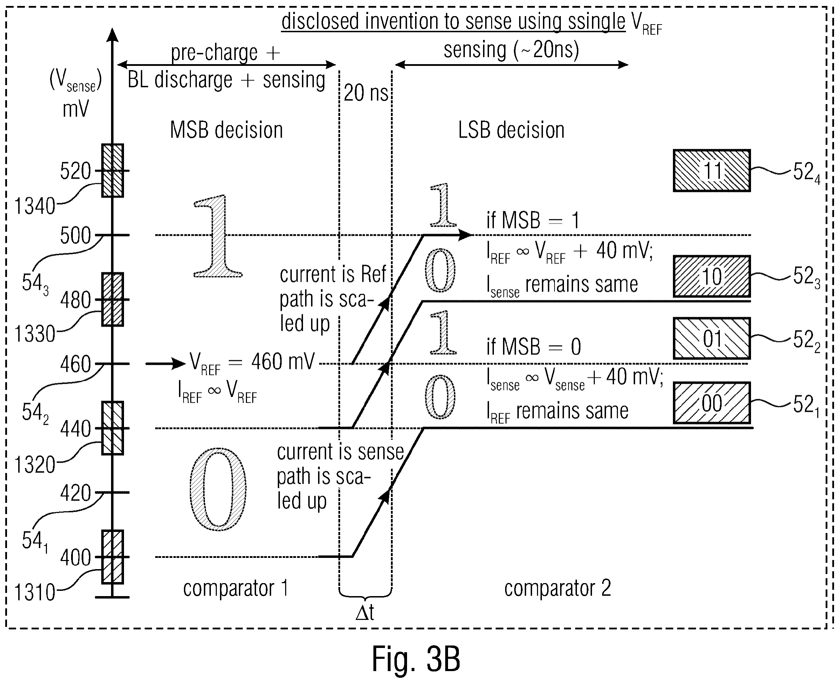

Fig. 3b shows a schematic diagram representing an amendment of the concept of Fig. 3a according to an embodiment of the present invention. For example, when using the same voltage ranges 1310 to 1340 of Fig. 3a, comparator 1 shown as comparator 24 in Fig. 1 may be configured to use the reference signal 16 as being the center $V_{REF}$ of 460 mV. A proportional current of $I_{REF}$ may be obtained.

Based on the result of the first decision, either $I_{REF}$ may be tuned with the electrical tuning current according to an offset in the $V_{REF}$ of +40 mV whilst $I_{sense}$ may remain the same, or the other way around, $I_{sense}$ being proportional to $V_{sense}$ may be tuned with an electrical tuning current proportional to +40 mV whilst $I_{REF}$ may remain the same. Therefore, virtually, threshold voltages $54_1$, $54_2$ and $54_3$ may be offset one to another.

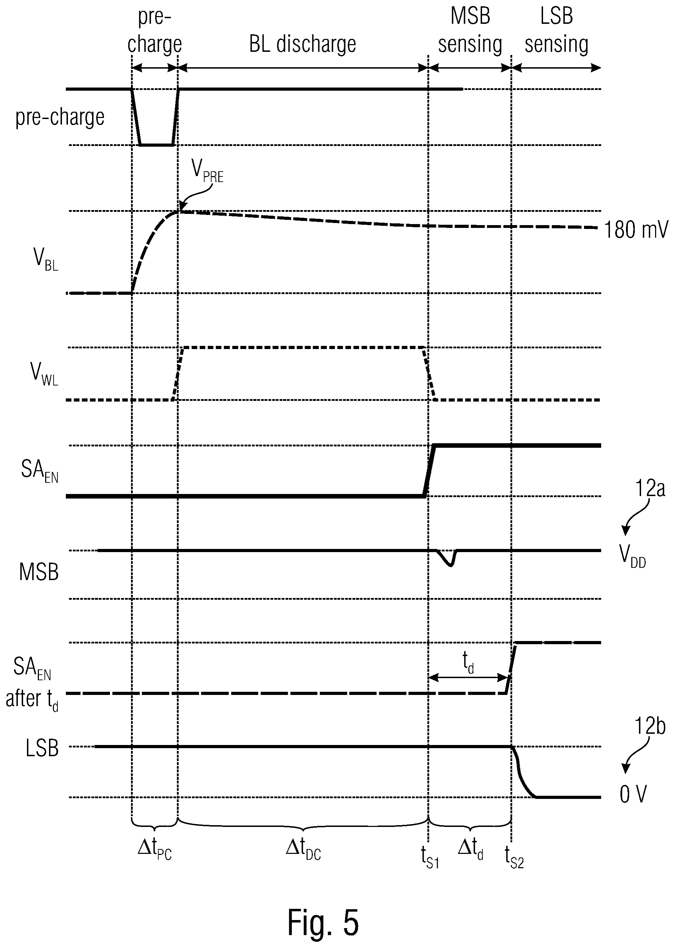

Such a configuration may benefit from a time interval $\Delta t$ forming a delay for the comparisons of comparator 2. The delay is sufficiently long to cover the sensing phase of the MSB, i.e., of comparator 1. Referring to Fig. 5, one can observe that there is a pre-charge phase $\Delta t_{PC}$ and a discharge phase $\Delta t_{DC}$ which are followed by the sensing phase. The first sensing phase is the phase where the MSB is evaluated..

In other words, according to embodiments, the use of three $V_{REF}$s is avoided by manipulating the currents in the second comparator to mimic the function of the two $V_{REF}$s used for LSB detection in conventional sequential sensing. BL precharge and discharge are performed once followed by two sensing phases for MSB and LSB detection.

A sensing method and a corresponding apparatus according to an embodiment may proceed like the conventional sequential sensing by deciding the MSB first followed by the LSB. Considering an example of the voltage to be sensed, $V_{sense}$ varying between 400 mV and 520 mV as shown in Fig. 3a for a conventional approach and in Fig. 3b according to an embodiment.

Sequential sensing conventionally uses a single comparator (Sense Amplifier) and senses multi-bit data in two stages i.e. the sensing phase must be repeated for LSB detection. Depending on the MSB, either $V_{REF}$ of 500 mV or 420 mV is used in the second stage. According to an embodiment, the need for two extra references is avoided by innovation at the circuit level. If MSB = 1, the voltage to be sensed is above 460 mV and we need a $V_{REF}$ of 500 mV (as in conventional sequential sensing, see Fig. 3a). The comparator of Fig. 2 essentially converts the BL voltage $V_{sense}$ and reference voltage $V_{REF}$ to equivalent currents and then compares them. Therefore, instead of using an absolute $V_{REF}$ of 500 mV, embodiments mimic the effect of the 40 mV increase in $V_{REF}$ by scaling up the current $I_{REF}$ proportionally. If MSB = 0, the voltage to be sensed is below 460 mV and we need a $V_{REF}$ of 420 mV (as in conventional sequential sensing, see Fig. 3a). Since embodiments aim to use the same $V_{REF}$ of e.g., 460 mV, for LSB detection, it is proposed to manipulate $V_{sense}$ so that voltages around 440 mV 'appear' as 480 mV (and therefore sensed as HIGH) and voltages around 400 mV 'appear' as 440 mV (and therefore sensed as LOW).

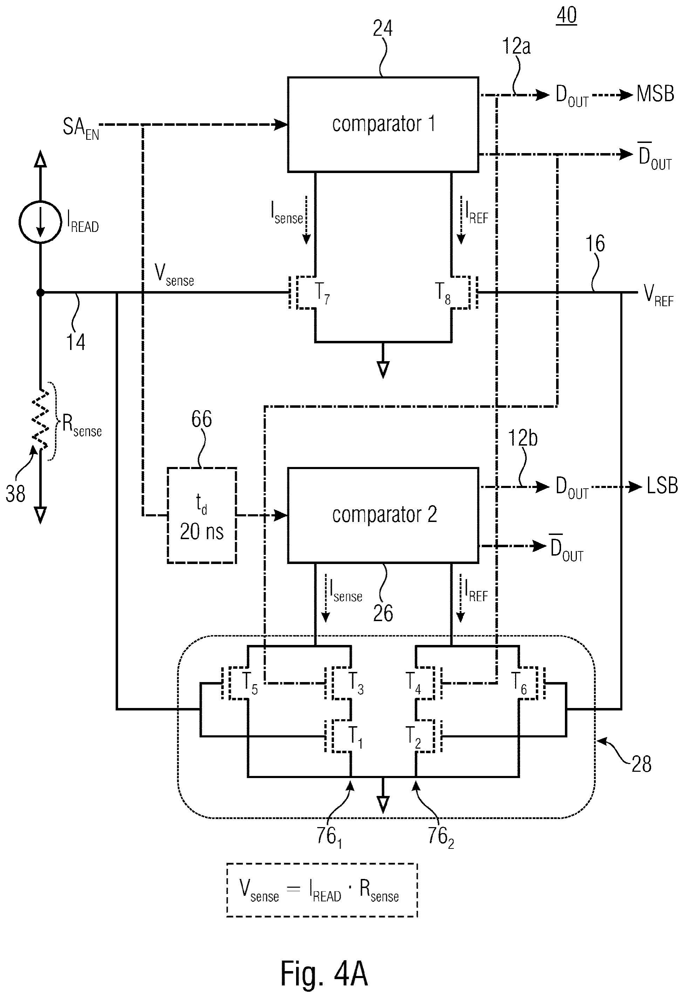

Fig. 4a shows a schematic block diagram of a comparator device 40 according to an embodiment. The current source circuitry 28 is adapted to tune signals $I_{sense}$ or $I_{REF}$ based on the first part 12a. According to an embodiment, the comparator circuit 24 is configured for providing the first part 12a of the evaluation results as a first output signal. The current source circuitry 28 may be configured for receiving the first output signal and may comprise a transistor arrangement, e.g., comprising transistors $T_1$ to $T_6$. The transistor arrangement may comprise a voltage/current characteristic that provides the electrical tuning current with an equivalent to the voltage difference based on the first output signal. That is, when considering paths $76_1$ and $76_2$ of the current source circuitry 28, one of the transistors may switch on or off the respective path and the other may provide for the tuning current based on the input signal 14, the reference signal 16 respectively, wherein the respective amplitude of the signal 14, 16, respectively leads to the respective current.

In other words, the effect of a 40 mV increase in $V_{sense}$ may be achieved by scaling $I_{sense}$ proportionally. This scaling up of currents in the sense path (if MSB was '0') or reference path (if MSB was '1') of Comparator-2 is accomplished by extra paths to sink current, as depicted in Figs. 4a-c. In Comparator-1, $V_{sense}$ and $V_{REF}$ are connected to two transistors $T_7$ and $T_8$ which decide $I_{sense}$ and $I_{REF}$, respectively. If $V_{sense} > V_{REF}$, $I_{sense} > I_{REF}$ resulting in $D_{OUT}$ of '1' and vice versa. In Comparator-2, in addition to transistors $T_5$, $T_6$ (which are connected to $V_{sense}$ and $V_{REF}$ as before), an additional path is introduced for current to sink through $T_3$ - $T_1$ for sense path and $T_4$ - $T_2$ for reference path.

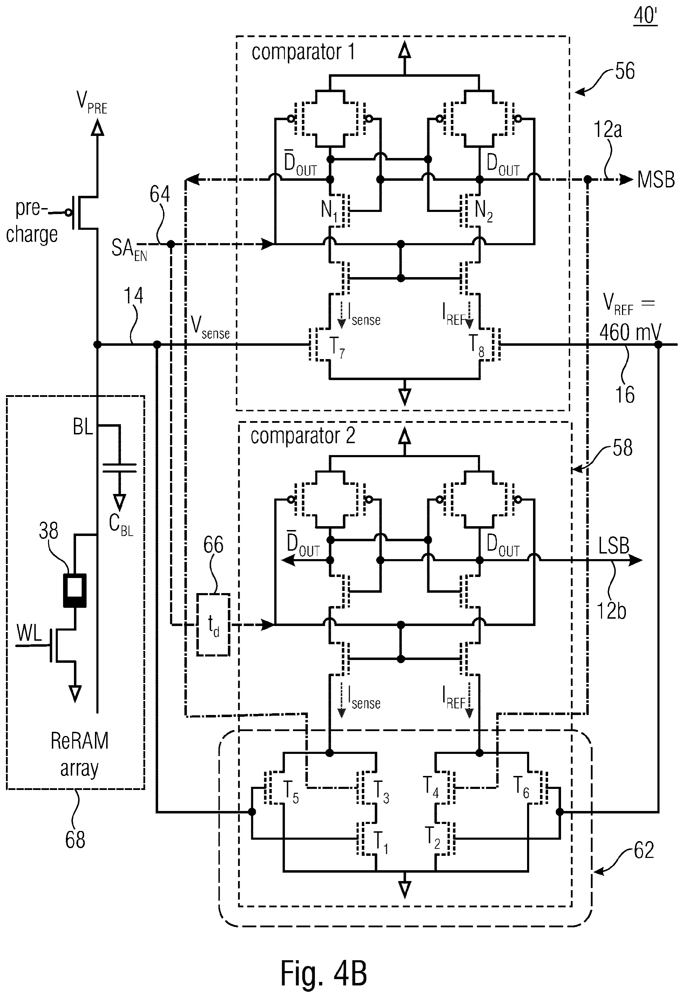

Fig. 4b shows a schematic block diagram of a comparator device 40' according to an embodiment. Comparator device 40' comprises several modifications over device 10 that may be implemented isolatedly, group-wise or all together. For example, comparator device 40' may comprise first comparator 56 that may be a modification or implementation of comparator circuit 24 in accordance with comparator 36 described in connection with Fig. 2.

Further, comparator device 40' may comprise a second comparator circuit 58 that may also be formed in accordance with comparator 36 shown in Fig. 2 and that may additionally comprise a current source circuitry 62. That is, when compared to Fig. 1, the second comparator may also comprise the current source circuitry. Fig. 4b shows an advantage implementation thereof but does not require that the current source circuitry 62 is implemented as shown when being a part of the second comparator.

The input signal 14 may be $V_{sense}$ described in connection with Fig. 2 and an enabling signal 64 referred to as $SA_{EN}$/SA_EN may start the respective comparison. In view of that, the comparator device 40' may comprise a delay element 66 coupled with the second comparator 58 and a source of the enabling signal 64 providing that the second comparator circuit 58 starts its comparison after the first comparator circuit 56 has finished its comparison. For example, the comparison of the first comparator 56 requiring an amount of several nanoseconds, e.g., 5 ns, 7 ns, 10 ns, 20 ns or the like may be compensated with the delay element 66 providing for a delay being at least the duration of the comparision, e.g., 50 ns or 20 ns. For example, 20 ns may be a typical duration of $\Delta t$. Here, $\Delta t$ may be the sensing phase associated with the MSB. Thereafter the LSB may be evaluated.

The current source circuitry 62 may comprise two branches, each branch having, e.g., two transistors $T_1$ and $T_3$, $T_2$, $T_4$, respectively. One of those transistors may be coupled to the output $D_{OUT}$, $\overline{D}_{OUT}$ respectively from which based on the structure of the first comparator 56 only one of both might be high, thereby switching the respective transistor $T_3$, $T_4$ respectively to a conductive state. The other transistor $T_1$ may be coupled to the input signal 14, the transistor $T_2$ to the reference signal 16, respectively.

A transistor $T_5$ may be coupled in parallel to transistors $T_1$ and $T_3$, whilst a gate terminal thereof may also be coupled to the input signal 14. In a similar manner, a transistor $T_6$ may be coupled in parallel to transistor $T_2$ and $T_4$ and a gate terminal thereof may be coupled to the reference signal 16.

Whilst transistors $T_1$, $T_3$ on the one hand and $T_2$ and $T_4$ may provide for a voltage controlled current source, i.e., the applied output signals of comparator 1 may cause the path to be conductive and the further transistor $T_1$, $T_2$ may provide for the additional tuning current, thereby influencing $I_{sense}$, $I_{REF}$ respectively for the second comparison.

According to the example presented in connection with Fig. 3b, the reference signal 16 may be set according to the center reference voltage of 460 mV, wherein this example is illustrative only and shall not limit the present invention.

The electrical resistance element 38 may be part of a ReRAM array 68 whilst this is also described for explanatory reasons only.

The second comparator 58 may provide for the second part 12b of the evaluation result, e.g., a least significant bit.

It is to be noted that although comparator device 40' is described to provide a possibility to distinguish between four states of a resistance value of the electrical resistance element 38, embodiments are not limited hereto but may also allow to decide between three states, e.g., when only tuning one of the input signal 14 and the reference signal 16, thereby providing for one additional threshold voltage or by adding further comparators as described below to obtain more than four states. That is, according to an embodiment, a comparator device is adapted to distinguish between at least three states of the input signal 14 using a voltage of the reference signal 16 as a single reference voltage.

According to an embodiment, the comparator device 40' is adapted to evaluate the electrical resistance value 38 providing the input signal 14, e.g., provided by a memory device, a strain sensor, a pressure sensor and/or a temperature sensor.

According to the specific example being provided in connection with Fig. 4b, the comparator device may be a read-out circuit, e.g., for a non-volatile memory device.

The evaluation result may comprise at least two bits of information derived from the input signal 14, wherein the first comparison is related to determining a first bit, MSB, of the at least two bits, wherein the second comparison is related to determining a second bit, LSB, of the at least two bits.

Transistors $T_1$, $T_2$, $T_3$ and $T_4$ may be implemented as a metal-oxide-semiconductor field effect transistor, MOSFET. This allows to provide for a comparator device that is configured for scaling the input signal or the reference signal of the second comparator circuit 62 based on the first part of the evaluation result and with a current source circuitry that comprises a MOSFET element as a voltage controlled current source configured for providing the tuning current with a current amplitude that corresponds to a difference of threshold values of the evaluation result.

Alternatively or in addition, the current source circuitry 62 may be configured for scaling the input signal or the reference signal for the second comparator circuit based on the first part of the evaluation result, wherein the input signal and the reference signal are provided as current signals, e.g., $I_{sense}$, $I_{REF}$, respectively, the signals being equivalent to the voltage signals thereof. By scaling the current signals with the electrical tuning current, this caused a scaling of the equivalent voltage signals.

According to an embodiment, the parts 12a and 12b of the evaluation result may be parts of a multi-bit decision of the input signal 14, wherein the input signal 14 is decided to be one of a multitude of predefined discrete states of a voltage of the input signal as described in connection with Fig. 3b. The input signal 14 may be decided to be one of the predefined discrete states being indicated, e.g., by ranges 1310 to 1340, each predefined discrete state being associated with a voltage range of the input signal. Between two adjacent voltage ranges 1310/1320; 1320/1330; 1330/1340, one of a plurality of possibly but not necessary equally spaced threshold voltages $54_1$ to $54_3$ may be arranged. The current source circuitry may be configured for providing the electrical tuning current that is associated with a voltage difference between two adjacent threshold voltages. In the example of Fig. 3b the thresholds are equally spaced by 40 mV.

Fig. 5 shows a schematic diagram of signals that may be obtained, for example, with the comparator device of Fig. 4b. Reference is made to Fig. 2 compared to which Fig. 5 shows the advantageous modifications of the present invention. It may be seen that starting from points in time $t_{S1}$ and $t_{S2}$ spaced by a time difference $\Delta t_d$ provided by the optional delay element 66 an MSB sensing and an LSB sensing may be obtained. For example, MSB or the first part of the evaluation result 12a may be considered to be a high level and LSB or the second part 12b may be considered to be a low signal that may correspond to a result "10" associated with state 1330 of Fig. 3b.

When referring again to Fig. 4b and the schematic block diagram of a circuit according to an embodiment, the circuit may be designed to sense four states using a single $V_{REF}$. Similar to two-state sensing, the read out may be performed in three phases that are illustrated by way of non-limiting example, in connection with Fig. 5 - BL precharge $\Delta t_{PC}$, BL discharge $\Delta t_{DC}$ followed by sensing starting on $t_{S1}$, $t_{S2}$ respectively. After pre-charge, the WL is activated and the BL discharges to one of different voltages according to the resistive state of the memory cell. When assuming that BL gets discharged from $V_{PRE}$ to 520 mV or 480 mV or 440 mV or 400 mV according to the four resistive states shown in Fig. 3b, such voltage may be considered as $V_{sense}$, the voltage to be sensed and may be fed to the two comparators in Fig. 4b.

In the following, the sensing phase is further elaborated. When the signal to start comparison, $SA_{EN}$, goes high, Comparator-1, i.e., comparator 56, is activated. Comparator-1 may decide the MSB. In Comparator-1, $V_{sense}$ and $V_{REF}$ are connected to two transistors $T_7$ and $T_8$ which decide $I_{sense}$ and $I_{REF}$, respectively. If $V_{sense}$ > $V_{REF}$, $I_{sense}$ > $I_{REF}$ resulting in $D_{OUT}$ of "1" and vice versa. Now MSB is detected.

As depicted in Fig. 4b, the $SA_{EN}$ may be delayed by $t_d$ using delay element 66 and fed to Comparator-2, i.e., comparator 58. This $t_d$ may be, for example, $\approx$ 20 ns or any other time that ensures that Comparator-1 has already provided a stable result on which the electrical tuning current of the subsequent comparator 58 may rely on. That is, $t_d$ may be selected to comprise at least the time needed for sensing operation of Comparator-1. Since LSB detection may depend on MSB detection, the sensed output of Comparator-1 (MSB and $\overline{MSB}$, $D_{OUT}$ and $\overline{D_{OUT}}$) is fed to Comparator-2 and hence, a sufficient delay of $t_d$= 20 ns may be advantageous. After this $t_d$ ns, Comparator-2 may be activated ($SA_{EN}$ is delayed by $t_d$ and connected to Comparator-2). In Comparator-2, in addition to transistors $T_5$, $T_6$ (which are

connected to $V_{sense}$ and $V_{REF}$ as in Comparator-1), an additional path may be introduced for current to sink a) through $T_3$ - $T_1$ for the sense path, i.e., related to $V_{Sense}$ and b) through $T_4$ - $T_2$ for the reference path, i.e., related to $V_{REF}$.

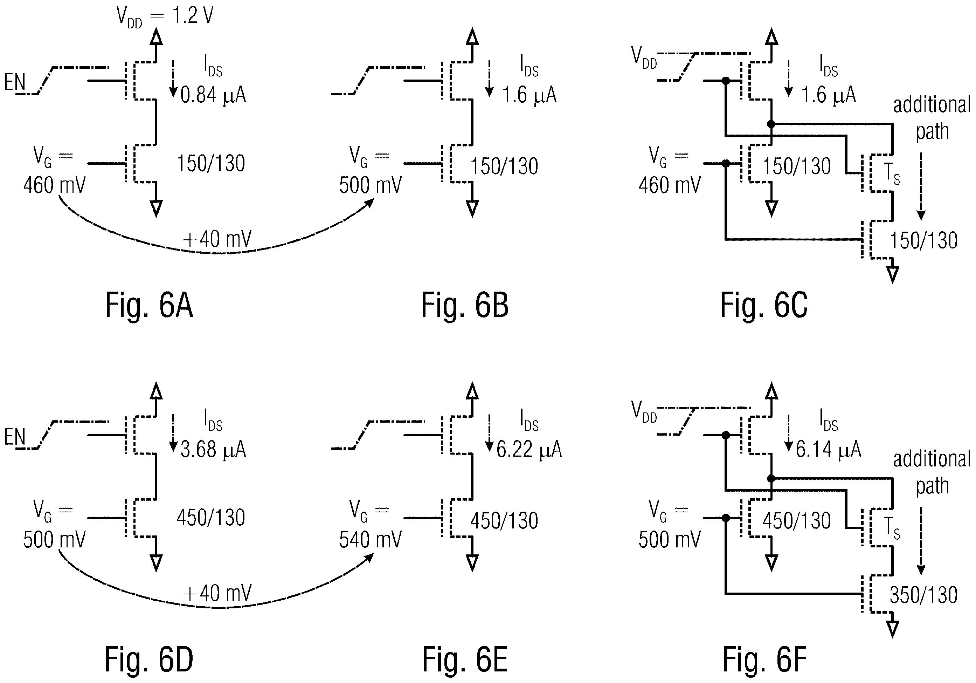

If MSB="1", the extra path formed by $T_4$ -$T_2$ in Comparator- 2 is available for $I_{REF}$ to flow in addition to the path through $T_6$. In this manner, the current $I_{REF}$ in Comparator-2 is scaled up to give the same effect if $V_{REF}$ of 500 mV was connected to the reference path in Comparator-2. In some embodiments, the width/length ratio (W/L) of the transistor $T_2$ is adjusted such that transistors $T_2$ and $T_6$ with 460 mV at their gate terminals sink the same current as a single transistor with 500 mV at its gate terminal (thereby achieving the same effect as a $V_{REF}$ of 500 mV). That is, the transistors $T_2$ and $T_6$ associated with the current source circuitry may be configured for sinking an increased current when compared to the comparator circuit, wherein the increase may correspond at least within a tolerance range to the additional tuning current provided by the current source circuitry. The specific amount of current provided may vary. For example, the increase in current to achieve a 40 mV increase in the gate voltage is dependent on the base voltage. As shown, for example, in Fig. 6, when the gate voltage of a transistor is 460 mV, a 40 mv increase in gate voltage to arrive at 500 mV may result in double the current. When the gate voltage, however, is 500 mV, a 40 mV increase in the gate voltage to arrive at 540 mV) may not result in double the current. Therefore, the transistors $T_1$ and $T_2$ associated with the current source circuitry may be configured, e.g, by adjusting the width of the transistor, for sinking an increased current corresponding to the predefined, aimed or required increase in the signals $V_{sense}/V_{REF}$.

Advantageously this path is ON only when MSB is HIGH since $D_{OUT}$ of Comparator-1 is connected to the gate of $T_4$. At the same time, $T_3$ - $T_1$ path is OFF since $\overline{D_{OUT}}$ of Comparator-1 is LOW and $I_{sense}$ of Comparator-2 is proportional to $V_{sense}$ connected to the gate of $T_5$. If MSB='0', $V_{sense}$ is below 460 mV and the circuit may be adapted to mimic a $V_{REF}$ of 420 mV for LSB detection. However, embodiments use the same $V_{REF}$ of 460 mV and manipulate $V_{sense}$ such that $V_{sense}$ "appears" to be ($V_{sense}$+40 mV) resulting in a similar offset when compared to reducing $V_{REF}$ by 40 mV. This manipulation of an increased $V_{sense}$ may be implemented by scaling up of $I_{sense}$, which is accomplished by $T_3$ - $T_1$ path. Note that $T_3$ - $T_1$ path is ON only when MSB=0 ($\overline{D_{OUT}}$ of Comparator-1 is HIGH). This extra path for $I_{sense}$ sinks in extra current proportional to an extra $V_{sense}$ of 40 mV. Hence $I_{sense}$ of Comparator-2 is now proportional to $V_{sense}$+40 mV. At the same time, $I_{REF}$ of Comparator-2 is proportional to $V_{REF}$ of 460 mV since $T_4$ - $T_2$ path is OFF because MSB is '0'. This results in a comparison between $V_{sense}$+ 40 mV and $V_{REF}$ = 460 mV in Comparator-2. If $V_{sense}$ is 400 mV, $I_{sense}$ which is proportional to 440 mV is compared with $I_{REF}$ which is proportional to 460 mV and $D_{OUT}$ of Comparator-2 is '0'. If $V_{sense}$ is 440 mV, $I_{sense}$ which is proportional to 480 mV is compared with $I_{REF}$ which is proportional to 460 mV and $D_{OUT}$ of Comparator-2 is "1".

In this manner, scaling up $I_{sense}$ results in correct LSB detection with the same $V_{REF}$ of 460 mV. The read-out is single stage because the Comparator-2 is activated just 20 ns ($t_d$) after activating the Comparator-1 and the whole reading operation takes the time of a single stage sensing (BL Pre-charge+ BL discharge + MSB sensing) followed by sensing phase of LSB. Hence the invention significantly improves the conventional sequential sensing in terms of power consumption and hardware as only a single reference may be sufficient instead of three references, while requiring the same time as conventional sensing.

In other words, Figs. 4b and 5 illustrate an embodiment of the present invention to sense multi-bit data by use of two comparators. Comparator 1 decides the MSB by comparing $V_{sense}$ and $V_{REF}$. If MSB is "1", current in the reference path of comparator 2 is scaled up to mimic $I_{ref}$ for $V_{REF}$ + 40 mV. If MSB is "0", current in the sense path of comparator 2 is scaled up to mimic $I_{sense}$ for $V_{sense}$ + 40 mV. Sample waveforms shown in Fig. 5 illustrate the multi-bit sensing. They correspond to the case $V_{sense}$ = 480 mV sensed as MSB = 1, LSB = 0.

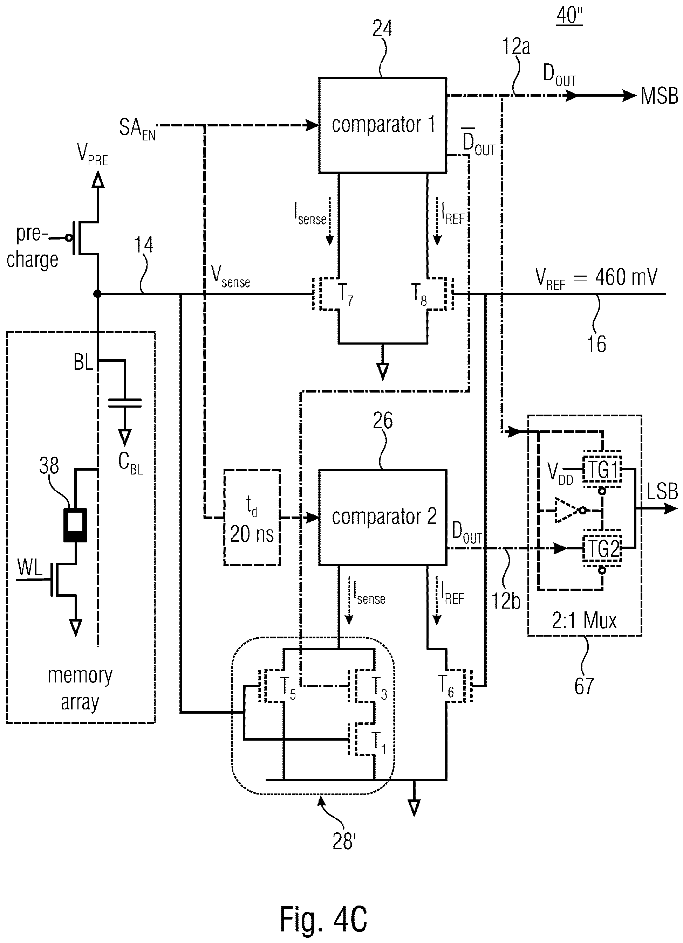

Fig. 4c is a schematic block diagram of a comparator device 40" according to an embodiment. When compared to the comparator device 10 of Fig. 4a, the device is adapted to tune only the measurement signal 14, i.e., $I_{sense}$ with the current source circuitry 28'. With such a configuration, three states of the input signal 14 may be separated.

Further, an optional multiplexer 67 is used to combine the parts 12a and 12b of the evaluation result.

In other words, Fig. 4c depicts the circuit for sensing three states. Suppose the resistance 38 is converted to sensing the three voltages 400mV, 440 mV and 480 mV. The suggested read-out circuit for sensing three states may be essentially the same as that for sensing four states, except for the minor modification in comparator 2, comparator 26 respectively and its output. Since there are three states separated by 40 mV or a different value, one could choose to have the $V_{REF}$ in between 400mV and 440 mV or between 440 mV and 480mV. In this circuit, a $V_{REF}$ between 440 mV and 480 mV is selected, e.g., 460 mV.

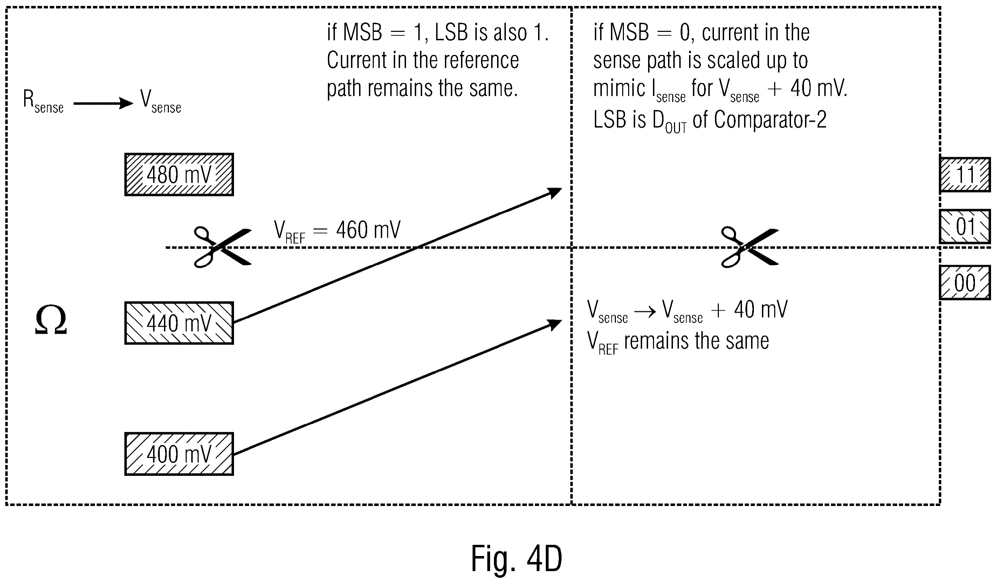

When $SA_{EN}$ goes high, $V_{sense}$ and $V_{REF}$ are compared in comparator circuit 24. This comparison logic is depicted in Fig. 4d. If the $V_{sense}$ is around 480 mV, this is greater than $V_{REF}$. Hence, $D_{out}$ of comparator 1 is HIGH and $\overline{D_{out}}$ is LOW. $D_{out}$ being HIGH turns ON TG 1 of multiplexer 67 (transmission gate) and the LSB is also HIGH. Hence, $V_{sense}$ of 480 mV may be sensed as "11". If $D_{out}$ of comparator circuit 24 is LOW, it means that $V_{sense}$ is below 460 mV. Also, $\overline{D_{out}}$ of comparator 24 is HIGH and this switches ON an additional path through transistors $T_3$ - $T_1$. Hence, $I_{sense}$ of comparator circuit 26 sinks a current proportional to $V_{sense}$ plus 40 mV. If $V_{sense}$ is approxi-

mately 440 mV, $I_{sense}$ sinks a current proportional to 480 mV and consequently $D_{out}$ of comparator circuit 26 is HIGH. In the same manner, if $V_{sense}$ is approximately 400 mV, $I_{sense}$ sinks a current proportional to 440 mV and consequently $D_{out}$ of comparator circuit 26 is LOW. Thus. $V_{sense}$ of 440 mV and 400 mV are detected as "1" and "0" at the output of comparator circuit 26. This is fed to the input of TG2 over the multiplexer 67. MSB being "0" may turn ON TG2 and thus the LSB is simply "1" and "0" for $V_{sense}$ of 440 mV and 400 mV respectively. To summarize, by the scaling of the currents in the sense path of comparator circuit 26, $V_{sense}$ of 480 mV, 440 mV and 400 mV are sensed as "11", "01" and "00" respectively.

This principle can be generalized as follows: to differentiate between three different states, the read-out circuit to differentiate between four states can be modified, as illustrated in Fig. 4c. In the similar way, to differentiate between five different states, the read-out circuit of the circuit to differentiate between eight states can be modified. In general, if a read-out circuit can distinguish between eight state, it can distinguish between a lower number such as 5 states or 7 states with appropriate modifications. In general, if a circuit can differentiate between N state, it can distinguish between N-1 states since it is a lesser problem.

Figs. 6a-f show, with reference to Figs. 3a and 3b, the way in which accurate current scaling is achieved by adding a voltage controlled current source using a transistor. Comparing Figs. 6b and 6c, it can be realized that Fig. 6c could sink the same current of 1.6 $\mu$A but with a gate voltage of 460 mV. Similarly, Fig. 6f shows a scenario where the same current as in Fig. 6e could be sunk. In this manner, the effect of a 40 mV increase of $V_{sense}/V_{REF}$ can be achieved.

According to an embodiment, the current source circuitry comprises a voltage controlled current source such as a transistor that is adapted to deliver, based on its size and/or ratio of width, W, and length, L, a predefined current amounting to the tuning current when being supplied with a predefined voltage. Signals $D_{OUT}$ and $\overline{D_{out}}$ may be fed, for example, to transistors $T_4$ and $T_3$ and transistors $T_3$ and $T_4$ may act as a switch configured to either turn ON the $T_1$-$T_3$ path or the $T_2$-$T_4$ path. The input signal and the reference voltage are applied to transistors $T_1$ and $T_2$. However, this is an example only on how to transfer the information obtained with, e. g. the first part of evaluation result to the second comparator to determine which signal is to be tuned, i.e., the input signal to be sensed or the reference signal. That is, the information obtained with, e.g., the first part of the evaluation result may be transferred to the electrical tuning current of predefined amplitude.

In other words, the current scaling technique to reproduce the effect of 40 mV increase in $V_{REF}$ is illustrated in Figs.6a-f. A simple circuit with an NMOS transistor connected to supply voltage $V_{DD}$ acts as an 'ENABLE' transistor (when it is ON, it enables the flow of current from $V_{DD}$ to ground) and the NMOS transistor below is the transistor of interest. To convert a 40 mV increase in $V_{REF}$ to an equivalent current, some embodiments use a voltage-controlled current source. For example, a NMOS transistor may behave as a voltage-controlled current source, e.g., providing a constant drain-to-source current according to the gate voltage in saturation region. Hence, a NMOS transistor operating in saturation region can be used to accomplish this requirement. In Fig. 6a and Fig. 6b it is illustrated the effect of 40 mV increase in gate voltage of a transistor. The numbers are based on simulation of a circuit according to an embodiment that uses industry standard tool in CMOS 130 nm process. When the EN signal goes high ($V_{DD}$), the circuit in Fig. 6a sinks 0.84 $\mu$A when the gate voltage is 460 mV. When the gate voltage is increased by 40 mV, the circuit sinks 1.6 $\mu$A. Since a 40 mV increase in gate voltage results in double the current in this embodiment, an additional path with a transistor of same (W/L) can result in the same current, as illustrated in Fig. 6c. Note that transistor $T_S$ in the additional path may act as a switch to turn ON the additional path. In this manner, the current produced by a gate voltage of 500 mV ($V_{sense}/V_{REF}$) can be reproduced with a gate voltage of 460 mV ($V_{sense}/V_{REF}$) and an additional path with appropriately sized transistor having the same gate voltage.

There are cases in which an increase of 40 mV at the gate voltage may not result in double the current. This was the case when the gate voltage was 500 mV and the W/L was 150/130, as shown in Fig. 6b. With a $\frac{W}{L}$ of $\frac{150}{130}$, a 500 mV gate voltage resulted in 1.6 $\mu$A current and 540 mV gate voltage resulted in 2.8 $\mu$A current. In such a case, adding an additional path will produce 2 $\times$ 1.6 $\mu$A = 3.2 $\mu$A and this might prevent to achieve 2.8 $\mu$A current with $\frac{W}{L}$ of $\frac{150}{130}$, e.g., as it may be difficult or impossible to reduce the size of the transistor in the additional path since it is the minimum $\frac{W}{L}$ in 130 nm CMOS process, resulting in difficulties using other processes. This can be solved by increasing the $\frac{W}{L}$ in the original path. As illustrated in Fig. 6d, when a $\frac{W}{L}$ of $\frac{450}{130}$ is used, the current is 3.68 $\mu$A and 6.22 $\mu$A for 500 mV and 540 mV respectively. To reproduce a current equivalent to 540 mV using a gate voltage of 500 mV, a transistor with $\frac{W}{L}$ of $\frac{350}{130}$ may be used in the additional path, see Fig. 6f. In this manner, an increase in $V_{REF}/V_{sense}$ of any quantity such as 20 mV, 40 mV, 50 mV, 60 mV, 75 mV, ... can be implemented by adding an additional path for current to sink and appropriately sizing the transistor.

The transistors shown in Figs. 6a-6f may be used on either path of the current source circuitry.

Embodiments relate to a circuit which can distinguish between three, four or more states, e.g., of a Resistive RAM cell, using a single $V_{REF}$. It has, amongst others, the following technical advantages:

1. The possibly foremost and the greatest advantage of the embodiments is the reduced complexity of the reference generator circuitry. All the prior art uses multiple $V_{REF}$s to sense multi-bit data. Although possibly having a lower sensing speed when compared to the prior art, the embodiment requires only a single reference voltage to distinguish between three or more states of the NVM cell. Generating multiple $V_{REF}$s using separate circuits or generating a single $V_{REF}$ and deriving other $V_{REF}$s from it using resistor network consume silicon area and consume power. Embodiments obviate the need to generate multiple $V_{REF}$s on chip, thus conserving on-chip power and area. This is crucial for portable electronic devices which invariably have NVMs in them.

2. Conventional sequential sensing require a control circuitry to switch between $V_{REF}$s during LSB sensing. As illustrated in Fig. 3a, if MSB is '1', then a higher $V_{REF}$ is needed and if MSB is "0", a lower $V_{REF}$ is needed. Based on the detected MSB, the control circuitry of known circuitries must disconnect the earlier $V_{REF}$ from the Sense Amplifier and connect the appropriate $V_{REF}$ to the Sense Amplifier. Embodiments allow to avoid such control circuitry as it is not needed since a single $V_{REF}$ may be used and the job of connecting the appropriate $V_{REF}$s is indirectly performed by four transistors ($T_1$, $T_3$, $T_2$, $T_4$). In other words, the control circuitry is highly simplified when compared to the control circuitry of related sequential sensing methods.

3. Comparator (Sense Amplifier) according to embodiments consumes very low power because the current comparators used in the disclosed circuit have 'automatic' cut-off capability once one of the nodes is pulled to ground. Referring to Fig. 4b, if $D_{OUT}$ is pulled to ground, $\overline{D_{out}}$ will be high and can still sink in current as long as $SA_{EN}$ is high. But $D_{OUT}$ being ground implies that $N_1$ is OFF cutting off a discharge path for $I_{sense}$ to flow. In this manner, the comparator circuitry of this embodiment is very energy efficient. Such a current comparator with automatic cut-off after MSB/LSB detection was proposed by T.Kobayashi et al [12]. However, using their voltage comparator and modifying it as described herein to perform a current comparison, the read-out circuit according to embodiments consume very low power for multi-bit sensing.

4. The disclosed circuit for multi-bit data is generic and can be used for any NVM technology and others, e.g., whose resistance can be converted to an equivalent voltage. Hence, it can used to sense multi-bit data of other resistive memory technology (Phase change Memory, STT-MRAM). Furthermore, it can even be used for sensing non-resistive memories (like Ferroelectric memories) as long as the non-volatile state can be converted to an equivalent voltage for sensing.

5. The disclosed circuit can be extended for sensing 3-bit data (distinguishing between eight states) by adding another comparator and appropriate modifications (three comparators in total). The circuit will still require only a single $V_{REF}$. Hence, the idea is scalable and lends itself easily to sense multi-bit data in NVM.

According to an embodiment, a comparator device is provided that comprises at least a third comparator circuit with a further current source circuitry associated with said third comparator circuit. The further current source circuitry may be adapted for providing a second electrical tuning current and the comparison provided by the further, third comparator circuit may be based on a scaling of one of the reference signal and the input signal to provide the third comparison as an equivalent to a decision about the input signal with regard to a decision threshold being different from the first comparison and from the second comparison, wherein the scaling of the third comparator circuit is based on the first part of the evaluation result and the second part of the evaluation result.

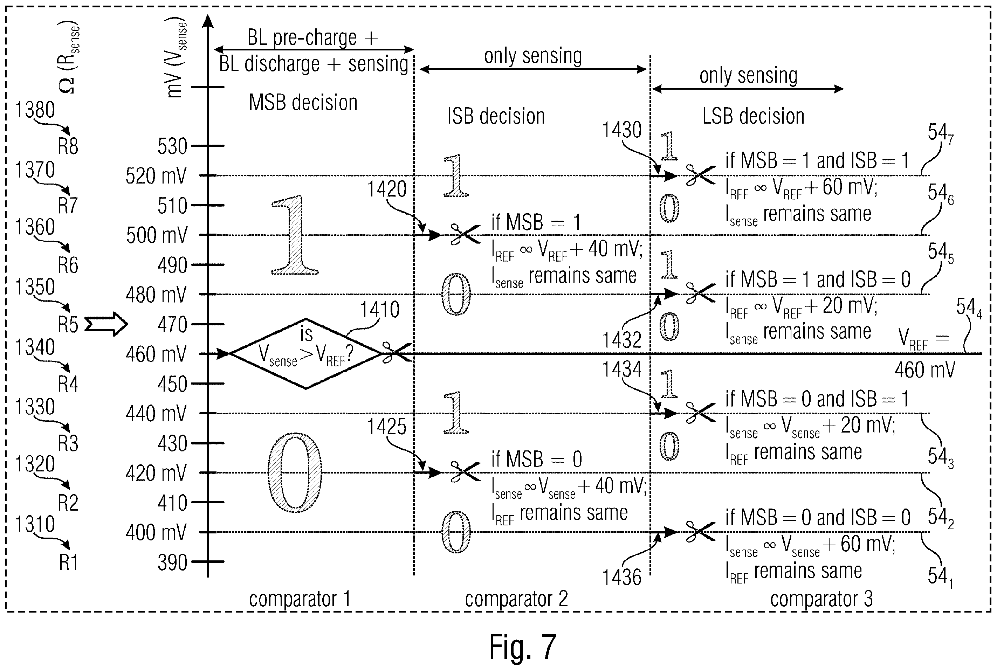

Fig. 7 shows an example of eight different states 1310 to 1380 associated with R1, R2, R3, R4, R5, R6, R7 and R8 relating to resistance values that correspond to voltages $V_{sense}$ to be sensed. Such a resistance to voltage conversion can be achieved by various means, e.g., pre charging the bit-line, BL, and allowing it to discharge by allowing current through the NVM cell. BL discharges in proportion to the resistance of the NVM cell.

With regard to the reference signal of 460 mV, the ISB decision may be tuned as described in connection with Fig. 4b, e.g., by using a difference proportional to 40 mV.

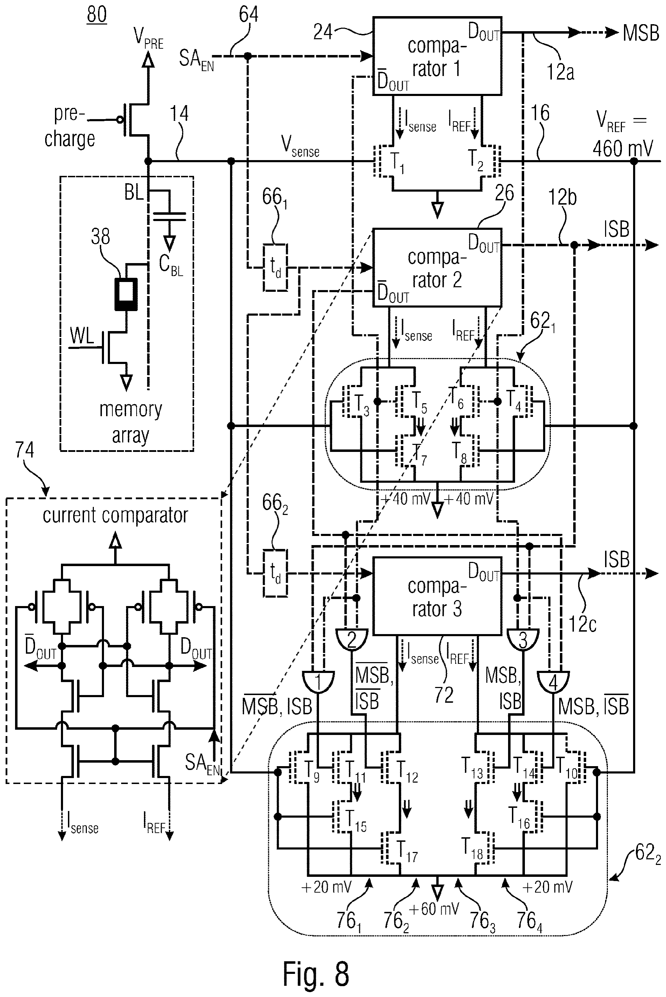

Referring now to Fig. 8, based on a selection of the respective path 76, through $76_4$, $V_{REF}$ or $V_{sense}$ may be tuned by 20 mV, or 60 mV and may, thus, allow to implement a functionality corresponding to seven threshold voltages $54_1$ to $54_7$.

Such a concept may be used for differentiating up to eight states as some of the states may also be combined to a common state as explained for the differentiation of three states. For differentiating between eight states, the principle may, thus, be essentially the same as when compared to the other embodiments beside that three comparators are used.

For differentiating between four states, two comparators may be used or may be sufficient. In general, to differentiate between n states, embodiments may use a number of $\log_2(n)$ comparators. In Fig. 7 an example is given where the resistance to be sensed is converted to an equivalent voltage and is ready to be sensed as a digital quantity. The eight resistive states $R_1$ to $R_8$ when converted to an equivalent voltage ($V_{sense}$) may have 20 mV difference between adjacent states. It is, again noted that those values are non-limiting example values only and may be vary based on the resistance to be sensed and the resistance to voltage conversion circuit.

Similar to 4-state sensing, $V_{REF}$ may be chosen to be the centre of the range of $V_{sense}$, the voltage to be sensed. Hence, $V_{REF}$ = 460 mV in the given example. The 8 resistive states may be sensed as a three-bit output with MSB (Most Significant Bit) denoting the leftmost bit, LSB (Least Significant Bit) denoting the rightmost bit and ISB denoting the intermediate bit. Other assignments are possible as they relate to the use of the gained information.

First, the quantity to be sensed, $V_{sense}$, is compared with $V_{REF}$ of 460 mV in Comparator-1 and the comparator outputs a logic '0' (0 V) or logic '1' ($V_{DD}$ V) as a result of a decision 1410, e.g., the first part of the evaluation result. This may be the MSB.

In a case where the MSB is a logic '1', this may mean that the quantity to be sensed is a voltage above 460 mV. Therefore, $V_{sense}$ varies between 470 mV and 530 mV.

To further differentiate between the remaining four states of the remaining two bits, a $V_{REF}$ in the center of $V_{sense}$ i.e. 500 mV may be used. In other words, the new $V_{REF}$ is preferably increased by 40 mV when compared to $V_{REF}$ used for MSB detection. This can be accomplished by scaling $I_{REF}$ to be proportional to $V_{REF}$+40 mV, as depicted in Fig. 8a for a decision 1420.

When now considering the case of MSB being logic '0',. This may result that the quantity to be sensed is a voltage below 460 mV. Therefore, $V_{sense}$ may vary between 390 mV and 450 mV. To further differentiate between these four states, a $V_{REF}$ in the center of $V_{sense}$ i.e. 420 mV may be used. In other words, the new $V_{REF}$ used in a decision 1425 is preferably 40 mV less than the $V_{REF}$ used for MSB detection. By using a single $V_{REF}$ and to enable detecting ISB using the same $V_{REF}$ of 460 mV, instead of subtracting 40 mV from $V_{REF}$ which is difficult to be implemented in a circuit, some embodiments propose to scale up $I_{sense}$ to be proportional to be $V_{sense}$ +40 mV, as depicted in Fig. 7. During this process, $I_{REF}$ remains the same i.e. $I_{REF}$ is proportional to 460 mV. In this manner, the ISB can be detected correctly after detecting MSB.

LSB detection is based on the detected values of MSB and ISB. If both MSB and ISB are logic '1', it means that the quantity to be sensed is between 510 mV and 530 mV in decision 1430. Embodiments may use a $V_{REF}$ of 520 mV which is 60 mV more than our original $V_{REF}$ of 460 mV. Hence, $I_{REF}$ may be scaled to be proportional to $V_{REF}$ +60 mV, as depicted in Fig. 7.

For the case of MSB being '1' and ISB being '0', $I_{REF}$ may be scaled to be proportional to $V_{REF}$ +20 mV to obtain a $V_{REF}$ of 480 mV in a decision 1432 to differentiate between 470 mV and 490 mV. The LSB detection for the remaining two cases is straightforward, in decisions 1434, 1436 respectively except that the current in the sense path is scaled since $I_{sense}$ is scaled and $I_{REF}$ remains unchanged.

Fig. 8 shows a schematic block diagram of such a comparator device being able to distinguish between eight different states. Comparator device 80 may comprise the comparator circuits 24 and 26 as described in connection, for example, Fig. 4b while the LSB of Fig. 4b is now an intermediate significant bit, ISB. A third comparator circuit 72 may be implemented as comparator circuits 24 and 26 and as shown in the block diagram 74.

Another delay element $66_2$ may be coupled with the third comparator to further delay the third comparison with regard to the second comparison that is already delayed when compared to the first comparison.

The additional current source circuitry $62_2$ associated with the comparator circuit 72 or being a part thereof may receive both parts 12a and 12b of the evaluation result, wherein the current source circuitry $62_2$ may comprise, for example, four paths $76_1$ to $76_4$ adapted differently when compared to the amount of current or voltage equivalent provided. For example, paths $76_1$ and $76_4$ may be adapted to provide an equivalent of 20 mV being provided for tuning either the input signal 14 (path $76_1$, the reference signal 16 (path $76_4$) respectively. Path $76_2$ and $76_3$ may be adapted, for example, to provide for an equivalent of 60 mV to the input signal 14, the reference signal 16 respectively. Based on the parts 12a and 12b one of the paths to tune either the input signal 14 or the reference signal 16 may be activated.

In other words, Fig. 8 depicts the circuit for differentiating between eight states. As illustrated in the left part of Fig. 8, the comparator 74 essentially compares currents in the two legs denoted $I_{sense}$ and $I_{REF}$.

If $I_{sense}$ > $I_{REF}$, $D_{OUT}$ is logic '1' and if $I_{sense}$ < $I_{REF}$, $D_{OUT}$ is logic '0'. Sensing of eight states is achieved by using three comparators and manipulating the currents in their left (sense path) and right legs (reference path). It is noted that terms like up, down, left, right, front or the like are used for illustrative purposes only and shall not limit the embodiments.

Considering the same range of $V_{sense}$ (390 mV to 530 mV), $V_{REF}$ 16 is chosen as 460 mV and applied to the transistors on right-hand side of the three comparators 24, 26, 72. The transistors on the left-hand side of the three comparators 24, 26, 72 are fed with $V_{sense}$ 14, the voltage to be sensed. $SA_{EN}$ is the signal to activate the comparator and when it goes high, comparison between the currents in sense and reference paths is performed. Comparator-2 is activated after a delay of $t_d$ after activating Comparator-1 and Comparator-3 is activated after a delay of 2 · $t_d$ or the sum of delay elements $66_1$ and $66_2$ after activating Comparator-1. This is because, as illustrated in Fig. 7, the detection is performed sequentially from MSB to LSB by Comparator-1 to Comparator-3. Figs. 7 and 8 thus show a principle of sensing of eight states using a single $V_{REF}$.

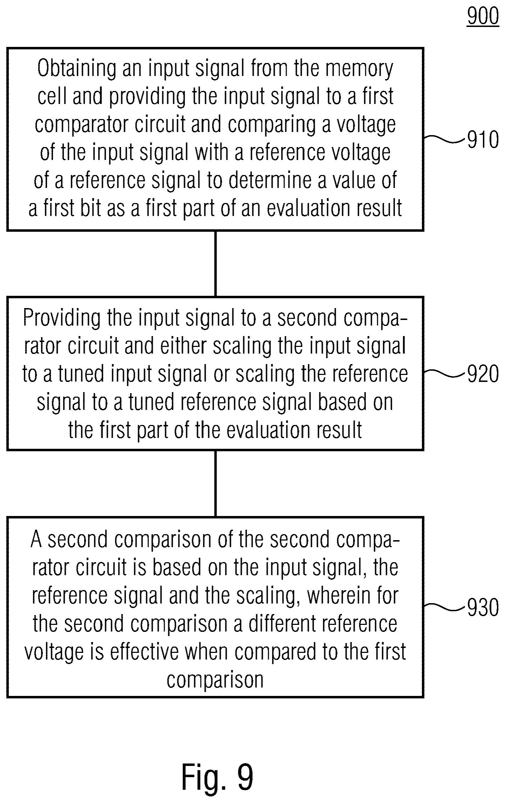

Fig. 9 shows a schematic flow chart of a method 900 according to an embodiment. A step 910 comprises obtaining an input signal from the memory cell and providing the input signal to the comparator circuit and comparing a voltage of the input signal with a reference voltage of a reference signal to determine a value of a first bit as a first part of an evaluation result. A step 920 comprises providing the input signal to a second comparator circuit and either scaling the input signal to a tuned input signal or scaling the reference signal to tuned reference signal based on the first part of the evaluation result. An implementation 930 defines that a second comparison of the second comparator circuit is based on the input signal, the reference signal and the scaling of step 920. This may result to mimic a different reference voltage or decision threshold when compared to the first comparison, i.e., for the second comparison a different reference voltage may be effective.

Devices described herein, in particular, comparator devices may be an integrated circuit or a part thereof.

As described herein, embodiments relate to a memory device comprising a multitude of memory cells and a comparator device described herein. The comparator device is configured for a read out of a memory cell for providing the evaluation result.

Embodiments relate to a technique to read data from multi-bit resistive RAM technology. In principle, this sensing can be used for any NVM technology or other resistor elements with little or no modifications.

Embodiments relate to a concept comprising devices and a method to read from multi-bit restive random access memory using single voltage reference. The non-volatile state of the memory cell (analog resistance) is converted to digital data (bits) using a single voltage reference. Emerging NVMs are increasingly being researched for multi-bit capabilities which can be exploited not only for storage (increased memory density) but also for novel in-memory applications like matrix vector multiplication and hyper-dimensional computing.

Such applications require read-out circuits, i.e., sense amplifiers, SAs, that convert the non-volatile state of the memory cell into digital data. Most of the multi-bit sensing schemes in prior-art require three references to sense 4 states, (N-1) references to distinguish between N states.

Embodiments relate to a circuit to distinguish between three, four or even more such as eight states using a single voltage reference. In principle, the circuit can be extended for sensing a higher number of states and it can still distinguish between, e.g., 8 states using a single reference, which appropriate delay. Furthermore, although the disclosure is related in the context of restive random access memory, embodiments can also be used for other emerging NVMS such as phase change memory, STT-MRAM or Ferroelectric tunnel junction FTJ, memory, whose state can be converted to an equivalent voltage when sensed. Either of the NVM may be considered as a memory which retain data without any source of electrical power. Embodiments are related to a type of NVM called resistive random access memory. Embodiments relate to a method to read from ReRAM cells which has multi-bit data stored in it. In other words, embodiments relate to an efficient integrated circuit to convert the analog state (resistance of the NVM cell) to digital bits.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

<u>References</u>

[1] E. Perez, C. Zambelli, M. K. Mahadevaiah, P. Olivo, and C. Wenger, ' "Toward reliable multi-level operation in rram arrays: Improving post-algorithm stability and assessing endurance/data retention," IEEE Journal of the Electron Devices Society, vol. 7, pp. 740-747, 2019.

[2] V. Milo, A. Glukhov, E. Perez, C. Zambelli, N. Lepri, M. K. Mahadeva- ' iah, E. P.-B. Quesada, P. Olivo, C. Wenger, and D. Ielmini, "Accurate program/verify schemes of resistive switching memory (rram) for in-memory neural network circuits," IEEE Transactions on Electron Devices, vol. 68, no. 8, pp. 3832-3837, 2021.

[3] C. Calligaro, V. Daniele, R. Gastaldi, A. Manstretta, and G. Torelli, "A new serial sensing approach for multistorage non-volatile memories," in Records of the 1995 IEEE International Workshop on Memory Technology, Design and Testing, 1995, pp. 21-26.

[4] C. Calligaro, R. Gastaldi, A. Manstretta, and G. Torelli, "A high-speed parallel sensing scheme for multi-level non-volatile memories," in Proceedings. International Workshop on Memory Technology, Design and Testing (Cat. NO.97TB100159), 1997, pp. 96-101.

[5] M. Bauer, R. Alexis, G. Atwood, B. Baltar, A. Fazio, K. Frary, M. Hensel, M. Ishac, J. Javanifard, M. Landgraf, D. Leak, K. Loe, D. Mills, P. Ruby, R. Rozman, S. Sweha, S. Talreja, and K. Wojciechowski, "A multilevel-cell 32 mb flash memory," in Proceedings ISSCC '95 - International Solid-State Circuits Conference, 1995, pp. 132-133.

[6] G. De Vita and G. Iannaccone, "A sub-1-v, 10 ppm/ °c, nanopower voltage reference generator," IEEE Journal of Solid-State Circuits, vol. 42, no. 7, pp. 1536-1542, 2007.

[7] I. A. Grout, Fabrication Processes for Integrated Circuits. London: Springer London, 2006, pp. 17-39.

[8] T. Lin, Y. Ho, and C. Su, "High-r poly resistance deviation improvement from suppressions of back-end mechanical stresses," IEEE Transactions on Electron Devices, vol. 64, no. 10, pp. 4233-4241, 2017.

[9] J. Lin, L. Wang, Y. Lu, and C. Zhan, "A nano-watt dual-output subthreshold cmos voltage reference," IEEE Open Journal of Circuits and Systems, vol. 1, pp. 100-106, 2020.

[10] I. Bhattacharjee and G. Chowdary, "A 0.3 nw, 0.093%/v line sensitivity, temperature compensated bulk-programmable voltage reference for wireless sensor nodes," IEEE Transactions on Very Large Scale Integration (VLSI) Systems, vol. 30, no. 9, pp. 1281-1293, 2022.

[11] "Tips and tricks for designing with voltage references." [Online].Available: https://www.ti.com/lit/eb/slyc147a/slyc147a.pdf

[12] T. Kobayashi, K. Nogami, T. Shirotori, and Y. Fujimoto, "A current-controlled latch sense amplifier and a static power-saving input buffer for low-power architecture," IEEE Journal of Solid-State Circuits, vol. 28, no. 4, pp. 523-527, 1993.

**Claims**

1. A comparator device for providing an evaluation result derived from comparing an input signal and a reference signal, the comparator device comprising:

   an interface (18) for receiving the input signal (14);
   a reference voltage source (22) for providing the reference signal (16);
   a first comparator circuit (24) configured for a first comparison based on the input signal (14) and the reference signal (16) and to provide a first part (12a) of the evaluation result (12);
   a second comparator circuit (26) configured for a second comparison based on the input signal (14) and the same reference signal (16) and to provide a second part (12b) of the evaluation result (12);
   a current source circuitry (28; 62) being associated with the second comparator circuit (26) and configured for, based on the first part (12a) of the evaluation result (12) and for the second comparison, providing an electrical tuning current for scaling the input signal (14) or for scaling the reference signal (16) with the electrical tuning current.

2. The comparator device of claim 1, adapted to evaluate an electrical resistance value (38) providing the input signal (14); wherein the electrical resistance value is part of a NVM device or is a resistance of a sensor device which senses a physical quantity as resistance such as a strain sensor, a pressure sensor, a temperature sensor or the like.

3. The comparator circuit of claim 1 or 2, being a readout circuit for a non-volatile memory device.

4. The comparator device of any one of the previous claims, wherein the evaluation result (12) comprises at least two bit of information derived from the input signal (14); wherein the first comparison is related to determining a first bit (MSB) of the at least two bits; wherein the second comparison is related to determining a second bit (LSB) of the at least two bits.

5. The comparator device of any one of the previous claims, adapted to distinguish between at least three states of the input signal (14) using a voltage of the reference signal (16) as a single reference voltage.

6. The comparator device of any one of the previous claims, configured for scaling the input signal (14) or the reference signal (16) of the second comparator circuit (26) based on the first part (12a) of the evaluation result (12); wherein the current source circuitry (28; 62) comprises a MOSFET element as a voltage controlled current source configured for providing the tuning current with a current amplitude that corresponds to an difference of threshold values of the evaluation result (12).

7. The comparator device of any one of the previous claims,
   wherein the current source circuitry (28; 62) is configured for scaling the input signal (14) or the reference signal (16) for the second comparator circuit (26) based on the first part (12a) of the evaluation result (12), wherein the input signal (14) and the reference signal (16) are provided as current signals equivalent to voltage signals thereof wherein scaling the current signals with the tuning current causes a scaling of the equivalent voltage signals..

8. The comparator device of any one of the previous claims, wherein the first part (12a) of the evaluation result (12) and the second part (12b) of the evaluation result (12) are parts of a multi-bit decision of the input signal (14), wherein the input signal (14) is decided to be one of a multitude of predefined discrete states of a voltage of the input signal (14), each predefined discrete states being associated with a voltage range of the input signal (14); wherein between two adjacent voltage ranges one of a plurality of threshold voltages is arranged; wherein the current source circuitry (28; 62) is configured for providing the electrical tuning current that is associated with a voltage difference between two adjacent threshold voltages.

9. The comparator device of any one of claim 8, wherein the first comparator circuit (24) is configured for providing the first part (12a) of the evaluation result (12) as a first output signal; wherein the current source circuitry (28; 62) is configured for receiving the first output signal and comprises a transistor arrangement having a voltage-/current characteristic that provides the electrical tuning current with an equivalent to the voltage difference based on the first output signal.

10. The comparator device of any one of the previous claims, comprising a delay element (66) coupled with the second comparator circuit (26); wherein the second comparator circuit (26) is adapted to start the second comparison after the first comparator circuit (24) has finished the first comparison based on the delay element (66).

11. The comparator device of any one of the previous claims, wherein the first comparator circuit (24) is adapted to indicate a most significant bit of a quantized value of the input signal (14); wherein the second comparator circuit (26) is adapted to indicate a less significant bit of a quantized value of the input signal (14).

12. The comparator device of any one of the previous claims, wherein the current source circuitry (28; 62) is a first current source circuitry ($62_1$) for providing the electrical tuning current as a first electrical tuning current, wherein the comparator device comprises at least a third comparator circuit (72) and a second current source circuitry ($62_2$) associated with the third comparator circuit (72) and adapted for providing a second electrical tuning current; wherein a comparison provided by the third comparator circuit (72) is based on a scaling of one of the reference signal (16) and the input signal (14) to provide the third comparison as an equivalent to a decision about the input signal (14) with regard to a decision threshold being different from the first comparison and from the second comparison, wherein the scaling of the third comparator circuit (72) is based on the first part (12a) of the evaluation result (12) and the second part (12b) of the evaluation result (12).

13. The comparator device of any one of the previous claims, being at least a part of an integrated circuit.

14. A memory device comprising a multitude of memory cells and a comparator device according to any one of the previous claims, wherein the comparator device is configured for a readout of a memory cell for providing the evaluation result (12).

15. Method for evaluating a multi-bit memory cell, the method comprising:

obtaining (910) an input signal from the memory cell and providing the input signal to a first comparator circuit and comparing a voltage of the input signal with a reference voltage of a reference signal to determine a value of a first bit as a first part of an evaluation result; and providing (920) the input signal to a second comparator circuit and either scaling the input signal to a tuned input signal or scaling the reference signal to a tuned reference signal based on the first part of the evaluation result; such that a second comparison of the second comparator circuit is based on the input signal, the reference signal and the scaling, wherein for the second comparison a different reference voltage is effective when compared to the first comparison.

Fig. 1

Fig. 2

Fig. 3A

Fig. 3B

EP 4 682 885 A1

Fig. 4A

$$V_{sense} = I_{READ} \cdot R_{sense}$$

Fig. 4B

Fig. 4C

if MSB = 1, LSB is also 1.
Current in the reference
path remains the same.

if MSB = 0, current in the
sense path is scaled up to
mimic $I_{sense}$ for $V_{sense}$ + 40 mV.
LSB is $D_{OUT}$ of Comparator-2

$R_{sense} \longrightarrow V_{sense}$

480 mV

$V_{REF}$ = 460 mV

$\Omega$

440 mV

$V_{sense} \rightarrow V_{sense}$ + 40 mV
$V_{REF}$ remains the same

400 mV

11

01

00

Fig. 4D

EP 4 682 885 A1

Fig. 5

Fig. 6A

Fig. 6B

Fig. 6C

Fig. 6D

Fig. 6E

Fig. 6F

Fig. 7

comparator 1

comparator 2

comparator 3

BL pre-charge +
BL discharge + sensing

only sensing

only sensing

MSB decision

ISB decision

LSB decision

$\Omega$ ($R_{sense}$)

mV ($V_{sense}$)

1380 → R8 — 530
1370 → R7 — 520 mV — 510
1360 → R6 — 500 mV — 490
1350 → R5 — 480 mV — 470
1340 → — 460 mV — 450
1330 → R4 — 440 mV — 430
1320 → R3 — 420 mV — 410
1310 → R2 — 400 mV — 390
R1

1410 — is $V_{sense} > V_{REF}$?

$V_{REF}$ = 460 mV

1420 — if MSB = 1
$I_{REF} \propto V_{REF} + 40$ mV;
$I_{sense}$ remains same

1425 — if MSB = 0
$I_{sense} \propto V_{sense} + 40$ mV;
$I_{REF}$ remains same

1430 — if MSB = 1 and ISB = 1
$I_{REF} \propto V_{REF} + 60$ mV;
$I_{sense}$ remains same — $54_7$

$54_6$

1432 — if MSB = 1 and ISB = 0
$I_{REF} \propto V_{REF} + 20$ mV;
$I_{sense}$ remains same — $54_5$

$54_4$

1434 — if MSB = 0 and ISB = 1
$I_{sense} \propto V_{sense} + 20$ mV;
$I_{REF}$ remains same — $54_3$

if MSB = 0 and ISB = 0
$I_{sense} \propto V_{sense} + 60$ mV;
$I_{REF}$ remains same — $54_2$

1436 — $54_1$

Fig. 8

900

Obtaining an input signal from the memory cell and providing the input signal to a first comparator circuit and comparing a voltage of the input signal with a reference voltage of a reference signal to determine a value of a first bit as a first part of an evaluation result ~910

Providing the input signal to a second comparator circuit and either scaling the input signal to a tuned input signal or scaling the reference signal to a tuned reference signal based on the first part of the evaluation result ~920

A second comparison of the second comparator circuit is based on the input signal, the reference signal and the scaling, wherein for the second comparison a different reference voltage is effective when compared to the first comparison ~930

Fig. 9

resistance of the NVM cell ---→ voltage to be sensed ---→ is $V_{sense} > V_{REF}$? | single bit sensing (2 states) } 1400

resistance of the NVM cell ---→ voltage to be sensed ---→ is $V_{sense} > V_{REF}1$? is $V_{sense} > V_{REF}2$? is $V_{sense} > V_{REF}3$? | multibit sensing (2 bit = 4 states) } 1000

1310   1320   1330   1340

400   420   440   460   480   500   520 mV   ($V_{sense}$)

00   01   10   11

$V_{REF}1$   $V_{REF}2$   $V_{REF}3$   (MSB, LSB) SAoutput

sequential sensing   1100

MSB is decided   yes   is $V_{sense} > V_{REF}2$?   no   } 1110

LSB is decided   yes   is $V_{sense} > V_{REF}3$?   no   yes   is $V_{sense} > V_{REF}1$?   no   } 1120

11   10   01   00

parallel sensing   1200

yes   is $V_{sense} > V_{REF}1$?   no   yes   is $V_{sense} > V_{REF}2$?   no   yes   is $V_{sense} > V_{REF}3$?   no

1   0   1   0   1   0

decoder

(MSB, LSB)

Fig. 10

Fig. 11

EP 4 682 885 A1

Europäisches
Patentamt
European
Patent Office
Office européen
des brevets

# EUROPEAN SEARCH REPORT

**Application Number**

EP 24 18 9216

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 748 546 A (BAUER MARK E [US] ET AL) 5 May 1998 (1998-05-05) * column 6, line 15 - column 7, line 11; figure 5 * ----- | 1-15 | INV. G11C11/56 |
| A | US 6 069 821 A (JUN SI BUM [KR] ET AL) 30 May 2000 (2000-05-30) * column 5, line 20 - line 60; figure 3 * ----- | 1-15 | |

**TECHNICAL FIELDS SEARCHED (IPC)**

G11C

The present search report has been drawn up for all claims

| Place of search | Date of completion of the search | Examiner |
|---|---|---|
| The Hague | 2 January 2025 | Knack, Steffen |

EPO FORM 1503 03.82 (P04C01)

## ANNEX TO THE EUROPEAN SEARCH REPORT
## ON EUROPEAN PATENT APPLICATION NO.

EP 24 18 9216

This annex lists the patent family members relating to the patent documents cited in the above-mentioned European search report.
The members are as contained in the European Patent Office EDP file on
The European Patent Office is in no way liable for these particulars which are merely given for the purpose of information.

02-01-2025

| Patent document cited in search report | | Publication date | Patent family member(s) | | Publication date |
|---|---|---|---|---|---|
| US 5748546 | A | 05-05-1998 | AU | 2593595 A | 04-01-1996 |
| | | | CN | 1150494 A | 21-05-1997 |
| | | | EP | 0763242 A1 | 19-03-1997 |
| | | | HK | 1011453 A1 | 09-07-1999 |
| | | | KR | 100287979 B1 | 02-05-2001 |
| | | | RU | 2190260 C2 | 27-09-2002 |
| | | | US | 5748546 A | 05-05-1998 |
| | | | US | 5828616 A | 27-10-1998 |
| | | | WO | 9534075 A1 | 14-12-1995 |
| US 6069821 | A | 30-05-2000 | JP | 3782628 B2 | 07-06-2006 |
| | | | JP | 2000173282 A | 23-06-2000 |
| | | | KR | 20000033906 A | 15-06-2000 |
| | | | TW | 404051 B | 01-09-2000 |
| | | | US | 6069821 A | 30-05-2000 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6747892 B2
- US 6069821 A
- US 7352618 B2
- US 20110149660 A1

**Non-patent literature cited in the description**

- **E. PEREZ** ; **C. ZAMBELLI** ; **M. K. MAHADEVAIAH** ; **P. OLIVO** ; **C. WENGER**. Toward reliable multi-level operation in rram arrays: Improving post-algorithm stability and assessing endurance/data retention. *IEEE Journal of the Electron Devices Society*, 2019, vol. 7, 740-747
- **V. MILO** ; **A. GLUKHOV** ; **E. PEREZ** ; **C. ZAMBELLI** ; **N. LEPRI** ; **M. K. MAHADEVA** ; **E. P.-B. QUESADA** ; **P. OLIVO** ; **C. WENGER** ; **D. LELMINI**. Accurate program/verify schemes of resistive switching memory (rram) for in-memory neural network circuits. *IEEE Transactions on Electron Devices*, 2021, vol. 68 (8), 3832-3837
- **C. CALLIGARO** ; **V. DANIELE** ; **R. GASTALDI** ; **A. MANSTRETTA** ; **G. TORELLI**. A new serial sensing approach for multistorage non-volatile memories. *Records of the 1995 IEEE International Workshop on Memory Technology, Design and Testing*, 1995, 21-26
- **C. CALLIGARO** ; **R. GASTALDI** ; **A. MANSTRETTA** ; **G. TORELLI**. A high-speed parallel sensing scheme for multi-level non-volatile memories. *Proceedings. International Workshop on Memory Technology, Design and Testing (Cat. NO.97TB100159)*, 1997, 96-101
- **M. BAUER** ; **R. ALEXIS** ; **G. ATWOOD** ; **B. BALTAR** ; **A. FAZIO** ; **K. FRARY** ; **M. HENSEL** ; **M. ISHAC** ; **J. JAVANIFARD** ; **M. LANDGRAF**. A multilevel-cell 32 mb flash memory. *Proceedings ISSCC '95 - International Solid-State Circuits Conference*, 1995, 132-133
- **G. DE VITA** ; **G. LANNACCONE**. A sub-1-v, 10 ppm/°c, nanopower voltage reference generator. *IEEE Journal of Solid-State Circuits*, 2007, vol. 42 (7), 1536-1542
- **I. A. GROUT**. Fabrication Processes for Integrated Circuits. Springer, 2006, 17-39
- **T. LIN** ; **Y. HO** ; **C. SU**. High-r poly resistance deviation improvement from suppressions of back-end mechanical stresses. *IEEE Transactions on Electron Devices*, 2017, vol. 64 (10), 4233-4241
- **J. LIN** ; **L. WANG** ; **Y. LU** ; **C. ZHAN**. A nano-watt dual-output subthreshold cmos voltage reference. *IEEE Open Journal of Circuits and Systems*, 2020, vol. 1, 100-106
- **I. BHATTACHARJEE** ; **G. CHOWDARY**. A 0.3 nw, 0.093%/v line sensitivity, temperature compensated bulk-programmable voltage reference for wireless sensor nodes. *IEEE Transactions on Very Large Scale Integration (VLSI) Systems*, 2022, vol. 30 (9), 1281-1293
- *Tips and tricks for designing with voltage references.*, https://www.ti.com/lit/eb/slyc147a/slyc147a.pdf
- **T. KOBAYASHI** ; **K. NOGAMI** ; **T. SHIROTORI** ; **Y. FUJIMOTO**. A current-controlled latch sense amplifier and a static power-saving input buffer for low-power architecture. *IEEE Journal of Solid-State Circuits*, 1993, vol. 28 (4), 523-527